(19) **Europäisches Patentamt European Patent Office Office européen des brevets**

(11) **EP 2 140 455 B1**

(12) **FASCICULE DE BREVET EUROPEEN**

(45) Date de publication et mention
de la délivrance du brevet:
**04.01.2012 Bulletin 2012/01**

(21) Numéro de dépôt: **08788068.8**

(22) Date de dépôt: **28.03.2008**

(51) Int Cl.:
***G11C 11/16*** (2006.01)

(86) Numéro de dépôt international:
**PCT/FR2008/050542**

(87) Numéro de publication internationale:
**WO 2008/135694 (13.11.2008 Gazette 2008/46)**

(54) **MEMOIRE MAGNETIQUE A JONCTION TUNNEL MAGNETIQUE**

MAGNETSPEICHER MIT MAGNETTUNNELÜBERGANG

MAGNETIC MEMORY WITH MAGNETIC TUNNEL JUNCTION

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **29.03.2007 FR 0754113**

(43) Date de publication de la demande:
**06.01.2010 Bulletin 2010/01**

(73) Titulaires:
- **Commissariat à l'Énergie Atomique et aux Énergies Alternatives**
  **75015 Paris (FR)**
- **Centre National De La Recherche Scientifique**
  **75794 Paris Cedex 16 (FR)**
- **CROCUS Technology**
  **38025 Genoble (FR)**

(72) Inventeurs:
- **DIENY, Bernard**
  **F-38250 Lans En Vercors (FR)**

- **NOZIERES, Jean-Pierre**
  **F-38700 Le Sappey En Chartreuse (FR)**
- **SOUSA, Ricardo**
  **F-38000 Grenoble (FR)**
- **REDON, Olivier**
  **F-38170 Seyssinet-pariset (FR)**
- **PREJBEANU, Ioan Lucian**
  **F-38360 Sassenage (FR)**

(74) Mandataire: **Vuillermoz, Bruno et al Cabinet Laurent & Charras "Le Contemporain" 50, Chemin de la Bruyère 69574 Dardilly Cédex (FR)**

(56) Documents cités:
**US-A1- 2005 018 475     US-A1- 2005 116 308**
**US-A1- 2006 154 381     US-A1- 2007 002 504**
**US-B1- 7 009 877**

## Description

## DOMAINE DE L'INVENTION

La présente invention se rattache au domaine des mémoires magnétiques, et notamment des mémoires magnétiques à accès aléatoire non volatiles, permettant le stockage et la lecture de données dans les systèmes électroniques. Plus précisément, elle concerne les mémoires à accès aléatoire magnétiques, appelées M-RAM (*Magnetic Random Access Memory*), à base de jonctions tunnels magnétiques.

## ETAT ANTERIEUR DE LA TECHNIQUE

Les mémoires magnétiques M-RAM ont connu un regain d'intérêt avec la mise au point de jonctions tunnels magnétiques (MTJ, pour "*Magnetic Tunnel Junction*") présentant une forte magnétorésistance à température ambiante. Ces mémoires magnétiques à accès aléatoire présentent de nombreux atouts :

- rapidité comparables à celle des SRAM (quelques nanosecondes de durée d'écriture et de lecture),
- densité comparable à la densité des DRAM
- non volatilité comme les mémoires FLASH,
- absence de fatigue à la lecture et à l'écriture,
- insensibilité aux radiations ionisantes.

Ce faisant, elles sont susceptibles de remplacer les mémoires de technologie plus traditionnelle, basées sur l'état de charge d'une capacité (DRAM, SRAM, FLASH) et ainsi devenir une mémoire universelle.

Dans les premières mémoires magnétiques réalisées, le point mémoire était constitué d'un élément dit "à magnétorésistance géante", constitué d'un empilement de plusieurs couches métalliques alternativement magnétiques et non magnétiques. Une description détaillée de ce type de structure peut, par exemple, être trouvée dans les documents US-A-4 949 039 et US-A-5 159 513 pour la structure de base, et dans le document US-A-5 343 422 pour la réalisation d'une mémoire RAM à partir de ces structures de base.

Cette technologie, de par son architecture, permet la réalisation de mémoires non volatiles avec une technologie simple, mais de capacité limitée. En effet, le fait que les éléments mémoire soient connectés en série le long de chaque ligne limite la possibilité d'intégration, puisque le signal est de plus en plus faible lorsque le nombre d'éléments augmente.

La mise au point des points mémoire à jonction tunnel magnétique (MTJ) a permis une augmentation significative des performances et du mode de fonctionnement de ces mémoires. Ces mémoires magnétiques à jonction tunnel magnétique ont, par exemple, été décrites dans le document US-A-5 640 343. Dans leurs formes les plus simples, elles sont composées de deux couches magnétiques de coercitivité différente, séparées par une couche mince isolante.

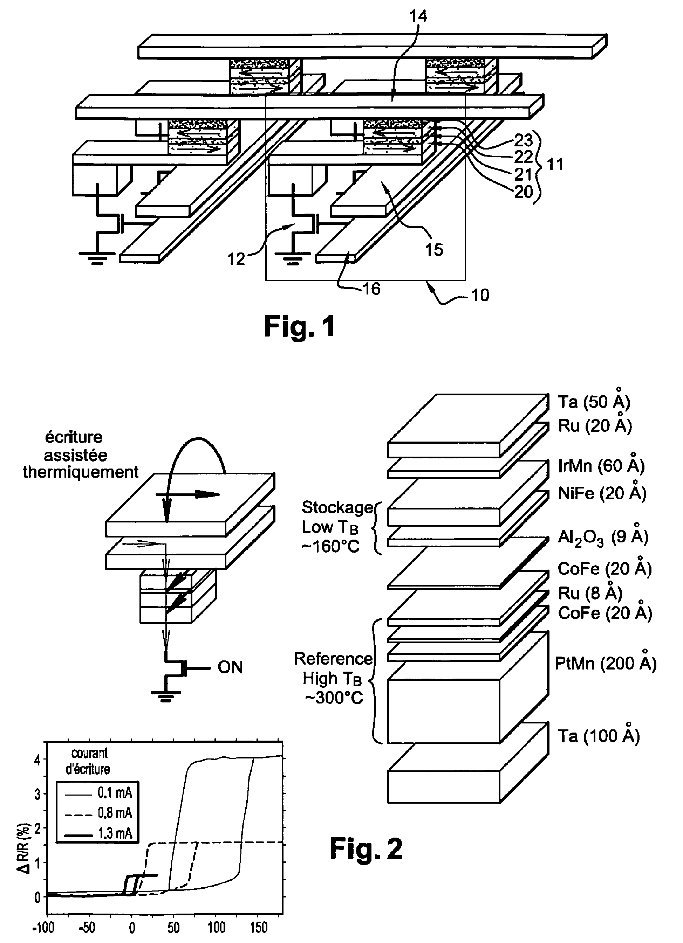

Ces MRAM à jonctions tunnels magnétiques ont fait l'objet de perfectionnements tels que par exemple décrits dans le document US-A-6 021 065 et dans la publication "Journal of Applied Physics" - Vol. 81, 1997, page 3758, et représenté au sein de la figure 1. Ainsi que l'on peut l'observer, chaque élément mémoire (10) est constitué de l'association d'un transistor CMOS (12) et d'une jonction tunnel MTJ (11). Ladite jonction tunnel (11) comporte au moins une couche magnétique (20) dite "couche de stockage", une fine couche isolante (21) et une couche magnétique (22) dite "couche de référence".

Préférentiellement, mais de manière non limitative, les deux couches magnétiques sont réalisées à base des métaux 3d (Fe, Co, Ni) et leurs alliages, et la couche isolante est traditionnellement constituée d'alumine ($Al_2O_3$). Préférentiellement, la couche magnétique (22) est couplée à une couche anti-ferromagnétique (23), dont la fonction est de piéger la couche (22), afin que son aimantation ne bascule pas, ou bascule de façon réversible sous l'effet d'un champ magnétique extérieur. Préférentiellement, la couche de référence (22) peut être, elle-même, constituée de plusieurs couches, comme par exemple décrit dans le document US-A-5 583 725, afin de former une couche anti-ferromagnétique synthétique.

Il est également possible de remplacer la simple jonction tunnel par une double jonction tunnel comme cela est décrit dans la publication Y.Saito et al., Journal of Magnetism and Magnetic Materials vol.223 (2001) page 293. Dans ce cas la couche de stockage est prise en sandwich entre deux couches fines isolantes, avec deux couches de référence situées du côté opposé desdites couches isolantes.

Lorsque les aimantations des couches magnétiques de stockage et de référence sont anti-parallèles, la résistance de la jonction est élevée. En revanche, lorsque les aimantations sont parallèles, cette résistance devient faible. La variation relative de résistance entre ces deux états peut typiquement atteindre 40 % par un choix approprié des matériaux constitutifs des couches de l'empilement et/ou de traitement thermique de ces matériaux.

Ainsi que déjà précisé, la jonction (11) est placée entre un transistor de commutation (12) et une ligne d'amenée de courant (14) (Word Line) formant une ligne conductrice supérieure. Un courant électrique passant dans celle-ci produit un premier champ magnétique. Une ligne conductrice (15) inférieure (Bit Line), généralement disposée de manière orthogonale par rapport à la ligne (14) (Word Line) permet, lorsqu'on y fait circuler un courant électrique, de produire un second champ magnétique.

Dans le mode écriture, le transistor (12) est bloqué, et aucun courant ne traverse donc le transistor. On fait circuler des impulsions de courant dans la ligne d'amenée de courant (14) et dans la ligne (15). La jonction (11) est donc soumise à deux champs magnétiques orthogonaux. L'un est appliqué selon l'axe d'aimantation difficile de la couche de stockage, également dénommée "couche libre" (22), afin d'y réduire son champ de retournement, tandis que l'autre est appliqué selon son axe de facile aimantation, afin de provoquer le retournement de l'aimantation et donc l'écriture du point mémoire.

Dans le mode lecture, le transistor (12) est placé en mode saturé, c'est-à-dire que le courant électrique traversant ce transistor est maximum, par l'envoi d'une impulsion de courant positif dans la grille dudit transistor. Le courant électrique envoyé dans la ligne (14) traverse uniquement le point mémoire, dont le transistor est placé en mode saturé. Ce courant électrique permet de mesurer la résistance de la jonction de ce point mémoire. Par comparaison avec un point mémoire de référence, on sait alors si l'aimantation de la couche de stockage (22) est parallèle ou anti-parallèle à celle de la couche de référence (20). L'état du point mémoire considéré (« 0 » ou « 1 ») peut ainsi être déterminé.

Les impulsions de champ magnétique générées par les deux lignes (14, 15) permettent, ainsi qu'on l'aura compris, la commutation de l'aimantation de la couche de stockage (20) lors du processus d'écriture. Ces impulsions de champ magnétique sont produites en envoyant des impulsions de courant courtes (typiquement 2 à 5 nanosecondes) et d'intensité faible (typiquement inférieure à 10 milliampères) le long des lignes de courant (14, 15). L'intensité de ces impulsions et leur synchronisation sont ajustées de sorte que seule l'aimantation du point mémoire se trouvant à l'intersection de ces deux lignes de courant (point sélectionné) peut commuter sous l'effet du champ magnétique généré par les deux conducteurs. Les autres points mémoires, situés sur la même ligne ou sur la même colonne (points demi-sélectionnés) ne sont, de fait, assujettis qu'au champ magnétique d'un seul des conducteurs (14, 15), et en conséquence ne se retournent pas.

De par le mécanisme d'écriture de ces points mémoire, on comprend clairement les limites de cette architecture.

L'écriture étant réalisée par un champ magnétique extérieur, elle est assujettie à la valeur du champ de retournement individuel de chaque point mémoire. Si la fonction de distribution des champs de retournement pour l'ensemble des points mémoire est large (en effet, elle n'est pas uniforme en raison des contraintes de fabrication et des fluctuations statistiques intrinsèques), il est nécessaire que le champ magnétique sur le point mémoire sélectionné soit supérieur au champ de retournement le plus élevé de la distribution, au risque de renverser accidentellement certains points mémoire situés sur la ligne ou sur la colonne correspondante, dont le champ de retournement, situé dans la partie basse de la distribution, est plus faible que le champ magnétique généré par la ligne ou la colonne seule. Inversement, si l'on souhaite s'assurer qu'aucun point mémoire ne soit écrit par une ligne ou une colonne, il faut limiter le courant d'écriture de telle sorte à ne jamais dépasser, pour ces points mémoire, le champ magnétique correspondant à la partie basse de la distribution, au risque de ne pas écrire le point mémoire sélectionné à l'intersection desdites ligne et colonne, si son champ de retournement est situé dans la partie haute de la distribution.

En d'autres termes, cette architecture à sélection par champ magnétique à l'aide de lignes et de colonnes ou conducteurs, peut facilement conduire à des erreurs d'adressage à l'écriture. Compte tenu de ce qu'il est attendu que la fonction de distribution des champs de retournement des points mémoire soit d'autant plus large que leur dimension est faible, puisque c'est la géométrie des points mémoire (forme, irrégularité, défaut) qui domine le mécanisme de renversement de l'aimantation, cet effet ne peut qu'empirer dans les générations de produits futurs.

Un autre inconvénient de ces mémoires de l'état de l'art concerne la stabilité de l'aimantation de la couche de stockage vis-à-vis des fluctuations thermiques lorsque la taille du point mémoire diminue. En effet la barrière d'énergie à franchir pour faire commuter l'aimantation de cette couche d'une orientation à l'autre est proportionnelle au volume de cette couche. Lorsque le volume diminue, la hauteur de barrière devient alors comparable à l'agitation thermique $k_B T$ où $k_B$ est la constante de Boltzman. L'information écrite dans la mémoire n'est alors plus conservée. Pour palier ce problème, on est obligé d'augmenter l'anisotropie magnétique de la couche de stockage en choisissant un matériau de plus forte anisotropie ou en accentuant l'anisotropie de forme du point mémoire par exemple s'il a une forme ellipsoïdale en augmentant son rapport de forme. Mais ce faisant, le champ nécessaire à la commutation magnétique augmente d'où une consommation électrique accrue pour générer le champ nécessaire à la commutation magnétique. Le courant dans les word et bit lines peut même à un certain stade dépassé le seuil limite imposé par l'électromigration dans ces lignes conductrices (typiquement de l'ordre de $2\,10^7 A/cm^2$)

Selon un perfectionnement décrit par exemple dans le brevet US-A-6 385 082, une impulsion de courant est envoyée à travers le point mémoire lors du processus d'écriture, en ouvrant le transistor (12), dans l'objectif d'induire un échauffement significatif dudit point mémoire. L'échauffement du point mémoire produit un abaissement du champ magnétique d'écriture requis. Pendant cette phase où la température du point adressé est significativement supérieure à celle des autres points mémoire, des impulsions de courant sont envoyées dans les lignes (14, 15) pour créer deux champs magnétiques orthogonaux, permettant la commutation de l'aimantation de la couche de stockage de la jonction considérée. Cette écriture, assistée thermiquement, permet d'améliorer la sélection à l'écriture, puisque seul le point mémoire sélectionné est échauffé, les autres points mémoire demi-sélectionnés sur la même ligne ou sur la même colonne restant à température ambiante. En d'autres termes, le perfectionnement décrit dans ce document vise à augmenter la sélectivité à l'écriture en échauffant la jonction adressée tout en gardant le concept de base d'écriture par envoi de deux impulsions de champs magnétiques orthogonaux.

D'autres méthodes d'adressage, également basées sur une élévation de température du point mémoire, mais utilisant un seul champ magnétique ou une commutation magnétique par injection de courant polarisé en spin dans la couche de stockage ont été décrites dans les documents FR 2 829 867 et FR 2 829 868.

La mise en oeuvre d'un tel chauffage du point mémoire sélectionné offre différents avantages, parmi lesquels on peut citer :

- une amélioration importante de la sélectivité à l'écriture, puisque seul le point mémoire à écrire est chauffé ;
- une amélioration importante de la sélectivité à l'écriture, en utilisant des matériaux à fort champ d'écriture à température ambiante ;
- une amélioration de la stabilité en champ magnétique nul (rétention) en utilisant des matériaux à forte anisotropie magnétique (intrinsèque ou liée à la forme du point mémoire) à température ambiante ;
- la possibilité de diminuer fortement la taille du point mémoire sans affecter la limite de stabilité, en utilisant des matériaux à forte anisotropie magnétique à température ambiante ;
- la réduction de la consommation électrique lors de l'écriture ;
- la possibilité de réaliser dans certaines circonstances, un stockage multi niveaux.

De façon préférentielle, la couche de stockage peut être, comme la couche de référence, couplée à une couche antiferromagnétique adjacente, mais dont la température de blocage $Tb1$ est plus faible que celle qui piège l'aimantation de la couche de référence ($Tb2$). Ainsi, lors de l'écriture, le pulse de courant qui traverse la jonction tunnel élève la température de la couche de stockage à une température légèrement supérieure à $Tb1$, de sorte que l'aimantation de la couche de stockage peut être commutée à l'aide du champ modéré appliqué sans affecter l'aimantation de la couche de référence. Ainsi, la gamme de température de fonctionnement du dispositif est limitée par l'écart entre $Tb1$ et $Tb2$. Ce faisant, si le pulse de courant d'échauffement produit une élévation de température $\Delta T$, et la température de stand by c'est-à-dire hors phase d'écriture est de $Ts$ (typiquement 40°C au dessus de la température ambiante), on doit avoir la double condition suivante :

$$Ts < Tb1 < Tb2$$

et

$$Tb1 < Ts + \Delta T < Tb2$$

En d'autres termes, la température de standby $Ts$ doit moins fluctuer que la différence $Tb2-Tb1$, typiquement 100°C. Il s'avère que la plupart des couches antiferromagnétiques ne présentent pas une température de blocage bien définie mais plutôt une distribution de température de blocage qui peut s'étaler sur 100°C, voire sur 200°C. En effet, lors du chauffage de la jonction tunnel magnétique légèrement au dessus de $Tb1$, il est possible que certains grains de la couche antiferromagnétique de référence (notamment ceux de la partie basse température de la distribution de température de blocage) commencent à commuter bien en dessous de la température de blocage $Tb2$ de l'ensemble de la couche de référence. Ce faisant, on aboutit à une dépolarisation partielle de l'aimantation de la couche de référence ce qui peut conduire à une baisse progressive du signal de magnétorésistance de la jonction tunnel, et au final, à des erreurs de lecture.

En conséquence, il apparaît souhaitable pour la couche de référence d'éviter le piégeage de l'aimantation de cette couche par couplage avec une couche antiferromagnétique pour éviter ces problèmes de dépolarisation progressive associés à une distribution de température de blocage et augmenter ainsi la fenêtre d'opération en température.

L'objet de l'invention est donc de satisfaire à cet objectif en mettant en oeuvre un autre mécanisme pour fixer l'orientation de l'aimantation de la couche de référence pendant la lecture. Il s'agit en l'espèce d'induire une interaction magnétostatique de ladite couche de référence avec une couche magnétique d'aimantation fixe et de manière générale avec un élément magnétique d'aimantation fixe.

En d'autres termes, l'invention vise ici à faire en sorte que l'aimantation de la couche de référence se trouve dans une direction fixe au moment de la lecture non pas parce qu'elle est en permanence piégée dans une direction fixe par couplage avec une couche antiferromagnétique adjacente comme dans l'art antérieur mais parce qu'elle est orientée ou ré-orientée dans une direction qui est toujours la même au moment de la lecture par interaction magnétostatique avec un autre élément magnétique d'aimantation fixe. Cet élément d'aimantation fixe est quant à lui soumis à des variations de température moindres au moment de la lecture et surtout de l'écriture que la couche de référence.

## EXPOSE DE L'INVENTION

Afin d'aboutir à ce résultat, la présente invention vise une mémoire magnétique à écriture assistée thermiquement, dont chaque point mémoire est constitué d'au moins une jonction tunnel magnétique, ladite jonction tunnel comprenant au moins :

- une couche magnétique de référence, dite couche « de référence », dont l'aimantation est toujours sensiblement dans la même direction au moment de la lecture ;
- une couche magnétique de stockage, dite couche « libre », dont la direction d'aimantation est variable ;
- une couche isolante interposée entre la couche de référence et la couche de stockage.

Selon l'invention, la couche de référence a sa direction d'aimantation orientée toujours sensiblement dans la même direction au moment de la lecture, par interaction magnétostatique avec une autre couche d'aimantation fixe appelée couche polarisante. L'aimantation de cette couche polarisante est piégée dans une direction fixe, et c'est le champ magnétostatique rayonné par cette aimantation piégée qui oriente l'aimantation de la couche douce toujours sensiblement dans la même direction au moment de la lecture.

De façon préférentielle, cette couche polarisante et la couche de référence avec laquelle elle est en interaction magnétostatique sont suffisamment proches pour favoriser cette interaction. Pour la même raison, les couches de référence et polarisante sont autant que faire ce peut dans une configuration de fermeture du flux magnétique assurant un bon couplage magnétostatique entre leurs aimantations.

Selon l'invention, cette couche polarisante est disposée de manière à être soumise, lors des phases de lecture mais surtout d'écriture, à des variations thermiques moindres que la couche de référence avec laquelle elle est en interaction magnétostatique.

Pour cela, il est avantageux d'insérer entre ces deux couches en interaction magnétostatique une couche de faible conductivité thermique, afin de limiter les variations thermiques de la couche polarisante lors des phases de lecture et surtout d'écriture, de préférence au dessus ou en dessous de l'empilement constitutif de la jonction tunnel.

L'empilement constitutif de la jonction tunnel est formé d'une couche de stockage (pouvant être constituée d'une couche ferromagnétique piégée par une couche antiferromagnétique, mais aussi d'une couche dont la coercitivité décroît très fortement à la température d'écriture), une couche de référence ferromagnétique et une barrière isolante en alumine ($Al_2O_3$), $TiO_2$ ou MgO de faible épaisseur (<2nm) qui sépare les couches de stockage et de référence. Cette couche de faible conductivité thermique est généralement située en contact par l'une de ses faces avec la jonction tunnel, et son autre face est en contact avec l'une des couches en interaction magnétostatique. Néanmoins on ne sortirait pas du cadre de l'invention en intercalant entre elles une ou plusieurs autres couches dès lors que se maintient l'interaction magnétostatique entre la couche de référence et la couche polarisante.

Cette couche polarisante peut elle-même avoir son aimantation piégée par association avec une couche en un matériau antiferromagnétique.

La couche de faible conductivité thermique située entre la couche de référence et la couche polarisante est avantageusement réalisée en GeSbTe ou BiTe

Selon l'invention, la couche de stockage est composée d'un bicouche associant une couche en un matériau ferromagnétique à aimantation planaire, typiquement choisi dans le groupe comprenant le Permalloy ($Ni_{80}Fe_{20}$), le $Co_{90}Fe_{10}$ ou d'autres alliages magnétiques contenant du Fe, Co ou Ni, et une couche antiferromagnétique de température de blocage modérée, typiquement mais de façon non-limitative comprise entre 120 et 220°C, et typiquement constituée de $Ir_{20}Mn_{80}$, l'épaisseur respective de ces deux couches étant typiquement choisie entre 1 à 4 nm pour la première et 4 à 8 nm pour la seconde.

Selon l'invention, la couche isolante visée dans la définition générale du point mémoire magnétique est choisie dans le groupe comprenant l'alumine ($Al_2O_3$), le $TiO_2$ et le MgO, cette couche isolante présentant un faible produit Résistance x surface (RA), typiquement compris entre 1 et 500 ohms.$\mu m^2$.

Selon une caractéristique de l'invention, une couche de faible conductivité thermique, typiquement choisie parmi le BiTe et le GeSbTe, est interposée entre la couche antiferromagnétique qui piège la couche de stockage et une couche métallique conductrice au niveau de la face opposée à la jonction tunnel. Cette couche de faible conductivité thermique est elle-même en contact ou séparée par une fine couche de protection d'une couche métallique conductrice, typiquement réalisée en cuivre (Cu) ou en tantale (Ta).

Selon une variante de l'invention, la polarisation de la couche de référence est réalisée au moyen d'une couche de polarisation insérée dans la ligne qui assure la connexion électrique au point mémoire.

Selon l'invention, la couche polarisante peut être composée d'un bicouche associant d'une part une couche réalisée en un matériau ferromagnétique, typiquement en alliage $Co_{1-x}Fe_x$, x étant compris entre 0 et 0.50, et d'autre part une couche antiferromagnétique de température de blocage élevée. La couche antiferromagnétique, qui fixe la direction de l'aimantation de la couche polarisante, peut être réalisée en PtMn ou en IrMn.

L'écriture du point mémoire peut résulter de la mise en oeuvre d'un champ magnétique, dit « d'écriture », généré par le passage d'un courant électrique dans une ligne de courant située à proximité du point mémoire, L'écriture dudit point mémoire peut également résulter de la polarisation en spin du courant qui traverse la jonction tunnel. Lorsqu'un champ magnétique d'écriture est mis en oeuvre, il est utilisé pour renforcer l'orientation de l'aimantation de la couche de référence.

Selon une autre forme de réalisation de l'invention, la polarisation de la couche de référence est réalisée au moyen d'aimants permanents positionnés de part et d'autre de la cellule mémoire et avantageusement au niveau de la couche de référence. Ces aimants permanents sont constitués de couches de matériaux ferromagnétiques à forte aimantation et fort champ coercitif, tels que choisis dans le groupe comprenant SmCo, CoPt, CoCrPt ou FePt. Alternativement, ces aimants peuvent être constitués de matériaux ferromagnétiques à forte aimantation tels que par exemple réalisés en un alliage CoFe, piégés par une couche antiferromagnétique avec une température de blocage élevée, notamment supérieure à 200°C.

Selon un autre mode de réalisation de l'invention, la polarisation de la couche de référence est réalisée au moyen d'un aimant permanent de polarisation, situé au dessus de la mémoire, cette dernière étant supposée contenir plusieurs points mémoires.

Selon l'invention, la couche de référence et la couche de polarisation peuvent respectivement être constituées d'un ensemble de couches ferromagnétiques couplées antiferromagnétiquement à travers un espaceur non-magnétique, notamment en ruthenium.

Selon encore un autre mode de réalisation de l'invention, on met en oeuvre une couche de référence laminée, constituée d'une première couche laminée polarisante qui se trouve piégée par une couche antiferromagnétique de type PtMn. La deuxième couche laminée est polarisée par un double effet additif: d'une part par le champ magnétostatique rayonné par la première couche laminée sur la deuxième et aussi par un couplage antiferromagnétique à travers un espaceur en ruthénium (Ru).

Selon cette configuration, la couche polarisante est avantageusement elle-même laminée, et est piégée par une couche antiferromagnétique, notamment en PtMn, la couche de référence laminée étant polarisée par ladite couche polarisante par couplage antiferromagnétique à travers un espaceur réalisé en Ruthénium, ce couplage venant s'ajouter au couplage magnétostatique entre ces couches.

Toujours selon cette configuration, la couche de référence est avantageusement en contact avec la barrière tunnel de la jonction tunnel magnétique, la dernière couche constitutive de la couche de référence laminée en contact avec ladite barrière tunnel étant susceptible d'être réalisée en un matériau ferromagnétique choisi dans le groupe comprenant CoFe, et CoFeB.

Avantageusement, le nombre d'empilements couplés antiparallèlement par un couche de Ru et constitués par l'ensemble couche de référence laminée / couche polarisante laminée est supérieur à deux, l'empilement le plus éloigné de la barrière tunnel étant piégé par interaction avec une couche en un matériau antiferromagnétique.

Avantageusement, les couches ferromagnétiques immédiatement en contact avec la barrière tunnel de la jonction tunnel magnétique et la couche de Ru sont plus épaisses que celles présentent au sein des couches laminées.

## BREVE DESCRIPTION DES FIGURES

La manière dont l'invention peut être réalisée et les avantages qui en découlent, ressortiront mieux des exemples de réalisation qui suivent, donnés à titre indicatif et non limitatif à l'appui des figures annexées.

La figure 1, déjà décrite, est une représentation schématique de l'architecture d'une mémoire magnétique de l'état antérieur de la technique, dont les points mémoire comprennent une jonction tunnel magnétique.

La figure 2 est une représentation schématique du principe de l'écriture du point mémoire de la figure 1, assistée thermiquement, ledit point mémoire étant également représenté, outre un graphe représentatif de la décroissance du piégeage de la couche de stockage au fur et à mesure de l'augmentation du courant de chauffage traversant la jonction tunnel.

La figure 3a est une représentation schématique de la structure d'un point mémoire conformément à une première forme de réalisation de l'invention, la figure 3b représentant la variation de la température en fonction de la position dans l'épaisseur de la structure.

La figure 4 illustre la fermeture de flux entre la couche polarisante piégée, caractéristique de l'invention, et la couche de référence, ainsi que le champ magnétique rayonné par la couche de stockage, dans le cadre de la forme de réalisation de l'invention décrite en relation avec les figures 3a et 3b.

La figure 5 est une représentation schématique de la structure d'un point mémoire conformément à une seconde forme de réalisation de l'invention, mettant en oeuvre deux barrières tunnel.

La figure 6a est une représentation schématique de la structure d'un point mémoire conformément à une troisième forme de réalisation de l'invention, dans laquelle la couche polarisante est intégrée dans l'une des lignes conductrices (bit line) dudit point mémoire, la figure 6b illustrant le principe sous-tendant le fonctionnement de cette structure particulière selon une variante de réalisation.

La figure 7 est une représentation schématique de la structure d'un point mémoire conformément à une quatrième forme de réalisation de l'invention, dans laquelle l'aimantation des couches qui le constitue est orientée hors du plan qui les contient.

La figure 8a est une représentation schématique de la structure d'un point mémoire conformément à une cinquième forme de réalisation de l'invention, mettant en oeuvre des aimants permanents, dont la figure 8b illustre le positionnement spatial.

La figure 9a est une représentation schématique de la structure d'un point mémoire conformément à la forme de réalisation précédente, mettant également en oeuvre des aimants permanents, dont la figure 9b illustre les champs magnétiques rayonnés.

La figure 10 est une représentation schématique de la structure d'un point mémoire conformément à une sixième forme de réalisation de l'invention, dans laquelle l'aimant permanent est situé au dessus du point mémoire.

La figure 11 est une représentation schématique de la structure d'un point mémoire conformément à une septième forme de réalisation de l'invention, dans laquelle la couche de référence se présente sous forme laminée.

La figure 12 est une représentation schématique de l'écriture d'un point mémoire avec un courant polarisé en spin et une polarisation de la couche de référence telle que décrite dans le mode de réalisation de la figure 11..

## MODES DE REALISATION DE L'INVENTION

On a représenté en relation avec la figure 2, le schéma du fonctionnement de l'écriture assistée thermiquement dans une cellule MRAM. Dans la partie supérieure gauche de cette figure, on a représenté la combinaison de l'échauffement par pulse de courant à travers la jonction et application d'un champ magnétique modéré créé par un pulse de courant dans la bit line.

La partie droite de la figure 2 illustre un mode de réalisation préférentiel de l'état antérieur de la technique dans le cadre d'un tel fonctionnement. On peut ainsi observer que les deux couches de référence et de stockage sont piégées par interaction avec une couche antiferromagnétique adjacente.

On a représenté dans la partie inférieure gauche de la figure 2 un graphe illustrant la décroissance du piégeage de la couche de stockage au fur et à mesure de l'augmentation du courant de chauffage traversant la jonction tunnel, et donc, les limites d'une telle structure.

La partie supérieure gauche de ladite figure illustre schématiquement la combinaison de l'échauffement de l'empilement par le biais d'une impulsion de courant à travers la jonction et d'un champ magnétique modéré créé par une impulsion de courant dans la « bit line ».

Selon la caractéristique essentielle de l'invention, la couche de référence du point mémoire de l'invention est associée à un élément polarisant, avec lequel elle est en interaction magnétostatique.

A cet effet, différents modes de réalisation peuvent être envisagés au sens de l'invention et qui vont être décrits ci-après plus en détail.

## 1. Point mémoire avec couche de polarisation séparée de la jonction tunnel par une barrière thermique

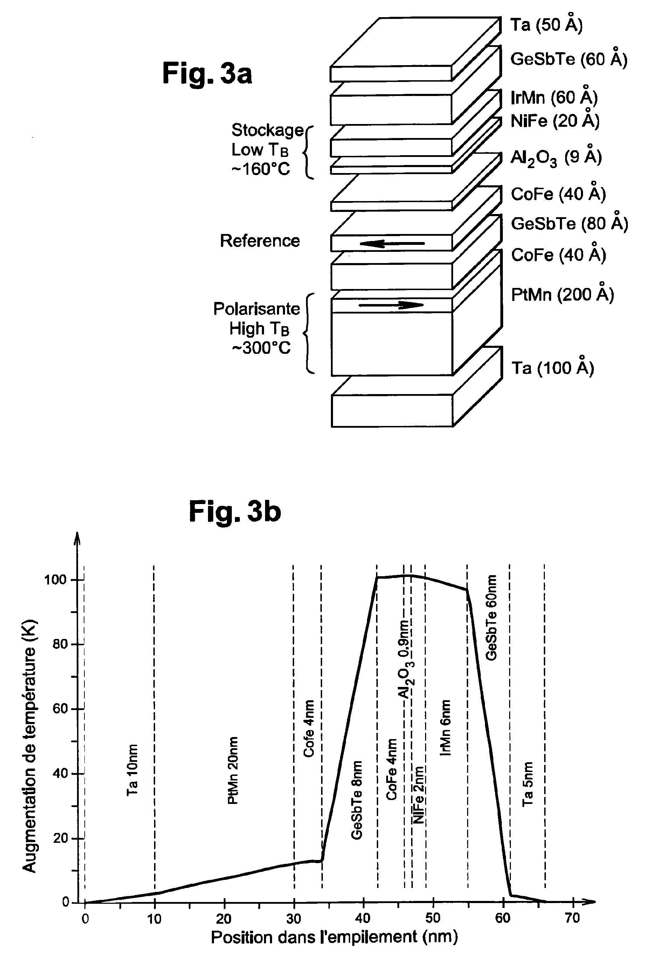

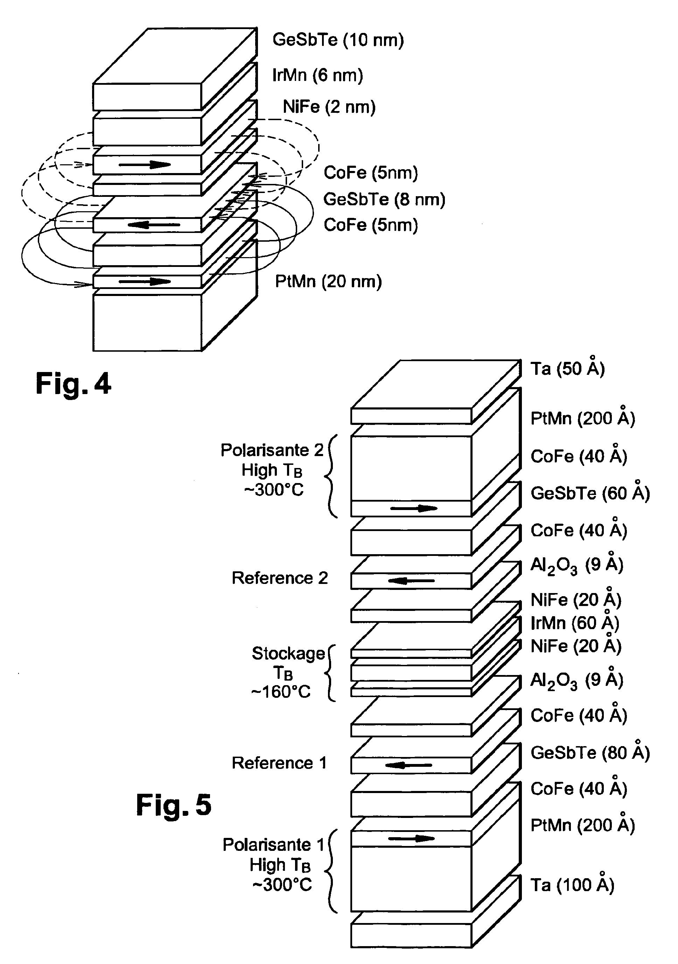

Selon un premier mode de réalisation, plus particulièrement décrit en relation avec les figures 3 et 4, l'empilement du point mémoire comprend une jonction tunnel avec une seule barrière isolante qui sépare les couches de référence et stockage.

La couche de stockage est composée d'une bicouche associant un matériau ferromagnétique à aimantation planaire (par exemple une couche de Permalloy $Ni_{80}Fe_{20}$ d'épaisseur de l'ordre de 1 à 4nm, ou de $Co_{90}Fe_{10}$ d'épaisseur 1 à 4 nm) et une couche antiferromagnétique de température de blocage modérée, c'est-à-dire de l'ordre de 120°C à 220°C. Cette température de blocage doit être suffisamment haute pour qu'à la température de standby (hors écriture), l'aimantation de la couche de stockage soit suffisamment piégée pour pouvoir conserver l'information pendant plusieurs années, mais cependant pas trop élevée pour ne pas nécessiter de chauffer de manière trop importante la jonction à chaque événement d'écriture, ce qui pourrait conduire à une dégradation des matériaux et augmenter la consommation électrique. Cette couche antiferromagnétique peut typiquement être constituée de $Ir_{20}Mn_{80}$ ayant une épaisseur de l'ordre de 4 à 6 nm.

Mais de façon alternative, la couche de stockage pourrait être formée d'une simple couche magnétique dont le champ coercitif varie fortement entre la température de fonctionnement hors écriture et la température d'écriture (typiquement entre 120 et 220°C).

La couche ferromagnétique de stockage est en contact avec une barrière tunnel de faible produit Résistance x surface (RA). Comme les jonctions tunnel en général sont limitées en tension par le claquage électrique, il est nécessaire d'abaisser suffisamment le produit RA pour pouvoir faire passer à travers la barrière tunnel un courant suffisamment fort pour provoquer l'échauffement de la couche de stockage au dessus de sa température de blocage. Suivant la composition des empilements utilisés, la densité de courant de chauffage nécessaire pour élever la jonction d'une température de l'ordre de 100°C peut varier de $10^5 A/cm^2$ à $10^7 A/cm^2$ suivant la présence ou non de barrières thermiques et l'efficacité de ces barrières (liées à leur épaisseur et à leur conductivité thermique). Des produits RA de l'ordre de 1 à 500$\Omega.\mu m^2$ conviennent pour accepter ces densités de courant. Des exemples de matériaux pour constituer la barrière tunnel sont l'alumine (épaisseur de l'ordre de 7 à 12 Angströms) ou le $TiO_2$ (épaisseur de 10 à 20 Angströms) ou le MgO (épaisseur de 10 à 25 Angströms).

Une couche de très faible conductivité thermique servant de barrière thermique est interposée, sur la face opposée par rapport à la couche de stockage, entre la couche antiferromagnétique qui piège la couche de stockage à la température de standby et l'électrode qui assure la connexion électrique. Cette couche a pour but d'augmenter l'efficacité du chauffage par le courant traversant la jonction en limitant la diffusion de la chaleur vers l'électrode qui assure la connexion électrique à la jonction tunnel du coté de la couche de stockage. Cette barrière thermique peut être en BiTe ou en GeSbTe d'épaisseur typiquement comprise entre 2 et 10nm. La barrière thermique est elle-même connectée électriquement à l'électrode directement ou par l'intermédiaire d'une couche conductrice par exemple en TiN ou TiWN.

Du côté opposé de la barrière tunnel par rapport à la couche de stockage se trouve une couche ferromagnétique dite de référence. L'aimantation de cette dernière pointe dans une direction fixe au cours de la lecture. Cette couche peut être constituée d'un alliage de CoFe ($Co_{90}Fe_{10}$, $Co_{70}Fe_{30}$, $Co_{80}Fe_{10}B_{10}$), de NiFe ($Ni_{80}Fe_{20}$), ou d'une bicouche CoFe 1nm/NiFe 2nm, la couche de CoFe étant située contre la barrière tunnel pour renforcer la polarisation en spin des électrons tunnel. L'épaisseur de cette couche peut être située dans la gamme d'environ 1 à 4 nm.

Dans l'état antérieur de la technique, l'aimantation de cette couche est en général piégée par une couche antiferromagnétique, ou alors cette couche fait partie d'une couche piégée antiferromagnétique synthétique constituée d'un empilement de deux couches ferromagnétiques couplées antiparallèlement à travers une couche de Ru, la deuxième couche ferromagnétique étant elle-même piégée à une couche antiferromagnétique (couche synthétique bien connue de l'homme du métier).

Dans la présente invention, et contrairement à l'état antérieur de la technique, la couche de référence n'est pas piégée par anisotropie d'échange et ne fait pas partie d'une couche piégée antiferromagnétique synthétique. La couche de référence est ici en contact ou, préférentiellement séparé par une couche mince de TiN ou TiWN servant de couche anti-diffusion d'une autre barrière thermique de même nature que celle décrite précédemment. Cette deuxième barrière thermique a aussi pour but de limiter la diffusion de la chaleur vers l'électrode située du côté de la couche de référence. De l'autre côté de la barrière thermique se trouve une couche ferromagnétique dite polarisante dont l'aimantation est piégée. Ce piégeage peut être assuré par couplage avec une couche adjacente antiferromagnétique par exemple en PtMn d'épaisseur de 20nm ou en IrMn d'épaisseur supérieure à 8nm.

Mais cette couche peut aussi être constituée d'une couche de forte coercitivité (type aimant permanent $Co_{80}Cr_{20}$ ou SmCo). Cette couche doit avoir un moment magnétique voisin de celui de la couche de référence de sorte que ces deux couches à aimantation planaire situées l'une au dessus de l'autre sont en configuration de fermeture de flux (voir figure 4), c'est-à-dire que leurs aimantations se couplent magnétostatiquement de façon antiparallèle et ne rayonnent pratiquement pas de champ au niveau de la couche de stockage.

Du fait de ce fort couplage magnétostatique, l'aimantation de la couche de référence se trouve elle-même indirectement polarisée par la couche polarisante piégée. L'avantage de cette approche par rapport à l'état antérieur de la technique réside dans la présence de la barrière thermique entre la couche de référence et la couche piégée polarisante, la couche polarisante piégée ne subissant ainsi que de faibles variations de température à chaque événement d'écriture. Du coup, la qualité de son piégeage n'est pas susceptible de se dégrader au cours du temps. Cette couche conserve une bonne polarisation pendant tout le fonctionnement du dispositif et assure donc à son tour une bonne polarisation de la couche de référence.

En résumé, la couche polarisante constituée d'une couche ferromagnétique piégée par une couche antiferromagnétique, est insérée dans l'empilement avec la jonction tunnel. La couche ferromagnétique polarisante n'est séparée de la couche de référence que par une barrière thermique qui permet de minimiser l'échauffement de la couche polarisante tout en étant suffisamment proche de la couche de référence pour que l'aimantation de cette dernière soit maintenue en alignement antiparallèle avec l'aimantation de la couche polarisante par couplage magnétostatique entre ces deux couches.

On montre en relation avec la figure 3b, le confinement de l'augmentation de la température entre les deux barrières thermiques lors du passage d'un courant au travers du point mémoire ainsi constitué, et parallèlement, une température des couches polarisantes représentant moins de 20 % de la température maximale.

La figure 4 précitée, illustre comme déjà dit la fermeture de flux entre la couche polarisante piégée et la couche de référence, et aussi le champ rayonné par la couche de stockage.

Les contraintes à prendre en considération lors la réalisation d'une telle structure sont les suivantes :

Il est préférable que les champs rayonnés par la couche polarisante et la couche de référence s'annulent au niveau de la couche de stockage. Cet objectif peut être réalisé avec un dimensionnement des couches de référence et polarisante tel que les champs magnétostatiques rayonnés au niveau de la couche de stockage aient une magnitude proche et des sens opposés. Dans ce cas le champ effectif agissant sur la couche de stockage est quasiment nul ou en tout cas fortement réduit par rapport au champ créé par chaque couche individuellement.

Dans le cas d'un champ effectif résiduel non nul agissant sur la couche de stockage, les courants nécessaires pour l'écriture des deux directions d'un point mémoire sont dissymétriques, mais l'écriture du bit reste encore possible. Il est même possible d'utiliser ce champ effectif résiduel pour imposer une direction à la couche de stockage et utiliser la ligne de champ pour écrire seulement le sens opposé. L'avantage qui en résulte est que la source de courant qui produit le courant envoyé dans la ligne de champ pour l'écriture peut être une source monopolaire au lieu de bipolaire, ce qui est rend cette source beaucoup plus compacte en technologie CMOS. Le champ rayonné par la couche de stockage elle-même contribue à la déstabilisation de la couche de référence quand la couche de stockage et la couche de référence sont aimantées dans la même direction, ce qui correspond à un état de faible résistance. Pour réduire ce champ déstabilisant sur la couche de référence, il est possible de réduire l'aimantation totale de la couche de stockage à travers une réduction de l'épaisseur de la couche et/ou l'utilisation d'un matériau à faible aimantation. Une autre possibilité pour réduire l'aimantation totale est la réalisation d'une couche de stockage avec une structure ferrimagnétique synthétique. Pour cette structure ferrimagnétique synthétique, l'aimantation effective de la couche de stockage est réduite par le couplage antiferromagnétique entre deux couches ferromagnétiques (FM) séparés par un espaceur de ruthénium (Ru) d'épaisseur typiquement entre 0,5nm et 1 nm, par exemple : FM / Ru 0,7nm / FM.

Si le champ rayonné par les couches de polarisation et de référence sur la couche de stockage est non nul et suffisant pour renverser l'orientation de la couche de stockage. Cette structure peut être utilisée pour l'écriture unipolaire, mais s'accompagne cependant de contraintes en termes de consommation en puissance.

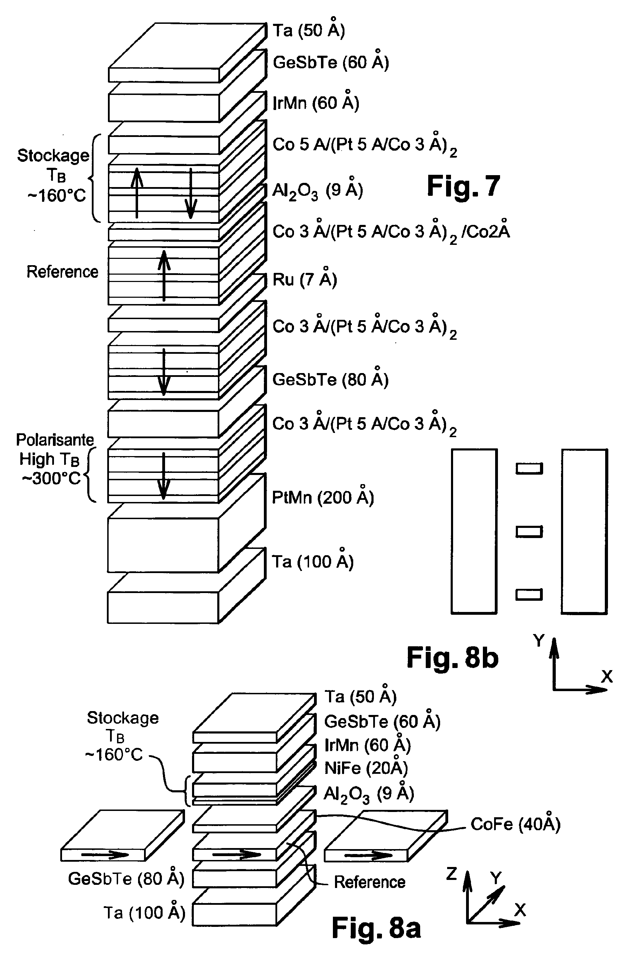

Une variation de ce mode de réalisation utilisant des couches magnétiques avec une aimantation hors du plan est illustrée dans la figure 7. Les couches à aimantation planaire sont remplacées par des multicouches Cobalt-Platine (Co/Pt). Dans ce cas la direction de l'aimantation est perpendiculaire au plan des couches.

## 2. Point mémoire à double barrière tunnel avec couche de polarisation séparée par une barrière thermique

Dans un second mode de réalisation illustré en relation avec la figure 5, l'empilement est constitué d'une structure à double jonction tunnel.

La couche de stockage est insérée entre les deux barrières tunnel, chaque barrière tunnel ayant du côté opposé à la couche de stockage une couche de référence, dont l'aimantation est maintenue dans une direction fixe au moment de la lecture par interaction magnétostatique avec une autre couche d'aimantation piégée.

Comme dans le mode de réalisation précédent, les deux couches de référence sont ici séparées des deux couches piégées chacune par une barrière thermique, dont le but est de confiner la chaleur dans la partie centrale de l'empilement au niveau où se trouve la couche de stockage. Ces barrières thermiques évitent également que les couches piégées ne subissent des variations de température trop importantes, évitant ainsi une dépolarisation progressive de leur aimantation.

Dans cet empilement, la couche de stockage est avantageusement constituée d'une tricouche du type CoFe 2nm/IrMn 5nm/CoFe 2nm, comprenant une couche centrale antiferromagnétique à température de blocage modérée (comme précédemment, de l'ordre de 160 à 220°C en IrMn ou PtMn ou PtPdMn), prise en sandwich entre deux couches ferromagnétiques de matériaux doux en contact avec les barrières tunnel. L'épaisseur de ces couches ferromagnétiques est typiquement de 1 à 5nm. Ces couches ferromagnétiques peuvent être réalisées en $Ni_{80}Fe_{20}$, $Co_{100-x}Fe_x$ avec x typiquement compris entre 0 et 30, $Co_{100-x-y}Fe_xB_y$, avec x typiquement compris entre 0 et 30, et y typiquement compris entre 0 et 20.

Comme précédemment les barrières tunnel peuvent être en alumine, $TiO_2$, MgO, avec des produits RA typiquement de l'ordre de 5 à 500 $\Omega.\mu m^2$. Il est important pour tirer le maximum d'efficacité du chauffage de cette structure, que les résistances des deux barrières soient aussi proches que possibles. En effet si une barrière a un produit résistance x surface $RA_1$ et la deuxième $RA_2$ et que les deux jonctions ont des tensions de claquage Vmax comparables, alors la densité maximale de courant qui pourra passer à travers le système sera de jmax=Min (Vmax/$RA_1$, Vmax/$RA_2$). La puissance maximale de chauffage par unité de surface de l'empilement sera alors de l'ordre de P/A = ($RA_1$+$RA_2$). $jmax^2$. Cette quantité est maximale pour un $RA_1$ donné lorsque $RA_2$ = $RA_1$.

Les barrières thermiques, les couches piégées et les couches antiferromagnétiques de piégeage sont typiquement constituées des mêmes matériaux que dans le précédent mode de réalisation. Les couches magnétiques piégées sont en configuration de fermeture de flux avec les couches de référence qui leur correspondent situées de chaque côté de la barrière thermique correspondante.

Les objectifs recherchés lors du dimensionnement de la couche de stockage, de la couche de référence et de la couche de polarisation sont les suivants :

■ réduction ou annulation du champ effectif au niveau de la couche de stockage, par compensation des champs magnétostatiques rayonnés par les couches de référence et les couches de polarisation (le champ effectif étant le résultat de la somme vectorielle des champs rayonnés par les couches de référence, de polarisation et couche de stockage incluant aussi l'éventuel couplage peau d'orange entre la couche de stockage et les couches de référence) ;
■ création d'un champ de polarisation dû à la couche polarisante au niveau de la couche de référence supérieur en module au champ rayonné par la couche de stockage au niveau de la couche de référence, l'écart entre ces deux champs devant être suffisamment grand pour permettre à l'aimantation de la couche de référence d'être maintenue parallèle au champ de polarisation quelque soit l'orientation de l'aimantation de la couche de stockage ;
■ le champ magnétique généré par la ligne d'écriture peut être aussi utilisé pour renforcer l'alignement de la couche de référence selon la direction souhaitée. Cela implique que lors de l'écriture d'un mot les points mémoire le long d'une ligne de champ soient écrits selon une première direction et dans un deuxième temps avec un champ qui stabilise la direction souhaitée pour la couche de référence opposée au champ initial.

Les champs rayonnés par les couches de polarisation et de référence ont des directions opposées au niveau de la couche de stockage. Le dimensionnement des aimantations (dépendant de l'épaisseur et/ou du choix des matériaux) de ces deux couches doit permettre d'annuler ou fortement réduire le champ effectif agissant sur la couche de stockage. Il faut que les moments magnétiques de ces deux couches soient proches l'un de l'autre, avec un moment légèrement plus grand pour la couche de polarisation pour compenser sa plus grande distance de la couche de stockage.

D'autre part pour minimiser le rayonnement de la couche de stockage sur la couche de référence, il est nécessaire que le moment magnétique de la couche de stockage soit significativement inférieur à celui des couches de polarisation et de référence. Il est possible de réduire ce moment magnétique de la couche de stockage par une réduction de l'épaisseur de cette couche et/ou l'utilisation d'un matériau à faible aimantation, ou encore par la réalisation d'une couche de stockage avec une structure ferrimagnétique synthétique. Cette structure peut être réalisée par deux couches ferromagnétiques (FM) séparés par un espaceur de Ru, FM/Ru/FM, d'épaisseur typique entre 0,5nm et 1nm. Le couplage antiferromagnétique induit par le Ru réduit l'aimantation effective ($M_{eff}$) de la structure à la différence d'aimantation entre les deux couches FM. Ce moment ne peut cependant pas être réduit à zéro car le couple exercé par le champ magnétique d'écriture est aussi réduit par la diminution du moment effectif ce qui rend difficile, voire impossible, l'écriture. Préférentiellement le moment effectif est équivalent à une couche de 1-1.5nm d'épaisseur, pour obtenir un champ coercitif faible et un moment réduit, avec des épaisseurs d'électrodes FM supérieures à 2nm.

L'avantage de cette structure à double jonction tunnel est de permettre un échauffement plus efficace de la tricouche de stockage. Ceci est dû d'une part, au fait que la puissance de chauffage est entre une et deux fois plus importante que pour une barrière simple, et d'autre part, en raison du fait que la structure étant essentiellement symétrique par rapport à la couche de stockage, le maximum de température est obtenu au niveau de la couche antiferromagnétique au coeur de la couche de stockage alors que dans la structure du premier mode de réalisation décrit, le maximum de température est immédiatement en contact avec la barrière tunnel. Il est préférable que le maximum de température soit situé dans la couche antiferromagnétique puisque c'est pour cette dernière que la température doit excéder la température de blocage.

En résumé, ce mode de réalisation concerne une structure duale, c'est-à-dire que la couche de stockage est au centre insérée entre deux barrières tunnel comprenant chacune une couche de référence polarisé par interaction magnétostatique avec une couche polarisante séparée de la couche de référence par une barrière thermique.

### 3. Polarisation par une couche de polarisation insérée dans la ligne qui assure la connexion électrique au point mémoire

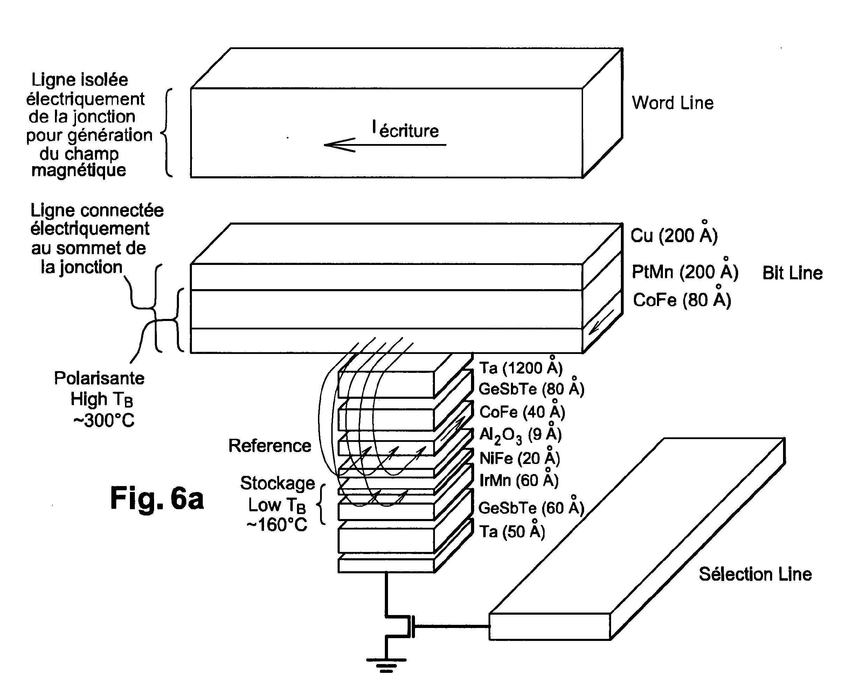

Selon un troisième mode de réalisation de l'invention, plus particulièrement décrit en relation avec la figure 6a, la couche piégée de polarisation est insérée au dessus de la jonction tunnel, à l'intérieur du conducteur qui assure la connexion électrique au sommet du pilier de la jonction tunnel. Compte tenu de l'éloignement plus important par rapport aux précédents modes de réalisation entre cette couche de polarisation et les couches magnétiques de stockage et de référence de la jonction tunnel, la fermeture de flux est moins bonne. De ce fait, le champ rayonné par la couche de polarisation agit à la fois sur l'aimantation de la couche de référence, mais également de façon significative sur l'aimantation de la couche de stockage. La valeur de ces champs rayonnés peut être calculée en utilisant des logiciels d'éléments finis comme FLUX3D [*CEDRAT : www.cedrat.com*]. Elle dépend de l'aimantation du matériau de la couche polarisante, de son épaisseur, de la largeur de la ligne conductrice et de la distance entre ladite ligne conductrice et les couches magnétiques considérées.

La direction de l'aimantation de la couche de polarisation est avantageusement orientée perpendiculairement à la longueur de la ligne de courant.

Comme représentée sur la figure 6a, la ligne conductrice peut être constituée de cette couche polarisante piégée (épaisseur typique de 4 à 15nm), d'une couche antiferromagnétique de piégeage, et complétée par une couche conductrice de Cuivre qui permet d'ajuster la résistance de la ligne par unité de longueur à la valeur souhaitée pour pouvoir amener au niveau de la jonction la densité de courant requise pour le chauffage. En raison de l'amplitude des champs rayonnés, il est préférable que la couche de polarisation soit située, parmi les différentes couches constitutives de la ligne conductrice, de manière la plus proche de la jonction tunnel.

L'existence d'un champ significatif rayonné par la couche polarisante sur la couche de stockage peut être utilisé de façon avantageuse : Si l'on veut faire commuter l'aimantation de la couche de stockage parallèlement à la direction du champ rayonné par la couche polarisante au niveau de la couche de stockage, il suffit de faire passer un courant de chauffage à travers la jonction sans nécessité de faire passer un courant d'écriture dans la bit line pour générer un champ magnétique. Le champ magnétique rayonné par la couche polarisante suffit à lui seul à orienter l'aimantation de la couche de stockage dans la direction désirée. En revanche, pour faire commuter l'aimantation dans la direction opposée au champ magnétique rayonné par la couche polarisante au niveau de la couche de stockage, il faut faire circuler dans la bit line un courant d'écriture permettant de générer au niveau de la couche de stockage un champ magnétique de sens opposé au champ magnétique rayonné par la couche polarisante et d'amplitude environ deux fois plus forte, de sorte que la somme des deux champs soit de l'ordre de l'opposé du champ rayonné par la couche polarisante. Ceci présente l'avantage que les pulses de courant nécessaires pour l'écriture sont toujours dans le même sens (alimentation en courant unipolaire), et en outre que ces pulses ne sont nécessaires que pour l'écriture d'un type de bits (« 0 » ou « 1 »). Le désavantage est que l'intensité du courant doit être plus forte que si la couche polarisante ne rayonnait pas de champ au niveau de la couche de stockage.

Par exemple, si le champ effectif (résultant de la somme vectorielle des champs rayonnés par la couche polarisante et la couche de référence, qui ont des directions opposées) au niveau de la couche de stockage est de l'ordre de 30 Oe, les pulses à fournir devront créer un champ de 60Oe au niveau de la couche de stockage au lieu de $\pm 30$ Oe s'il n'y avait pas de champ rayonné par la couche polarisante au niveau de la couche de stockage. Le courant étant double, la puissance requise est multipliée par 4. Par ailleurs, pour une largeur de ligne donnée, la densité de courant nécessaire étant doublée, cette approche est plus susceptible de souffrir de problèmes d'électromigration au niveau de la word line.

Le mode de réalisation ainsi décrit implique que la « word line » soit parallèle à la « bit line ». Il nécessite donc de produire autant de champs magnétiques d'écriture que de bits « 1 » à écrire, ce qui s'avère très consommateur en puissance.

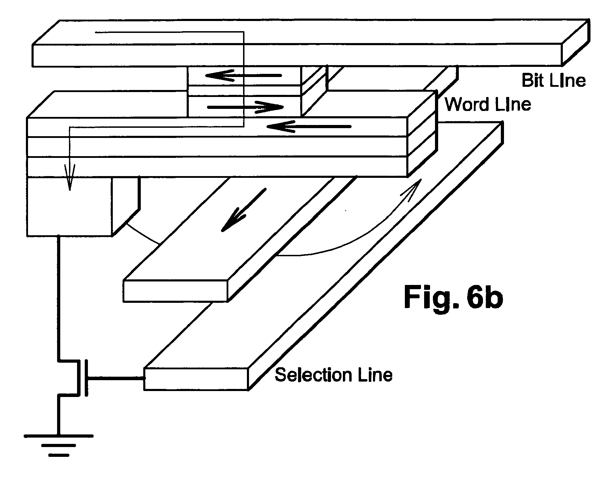

Pour revenir à une consommation plus raisonnable, il est préférable d'intégrer la couche polarisante dans la partie inférieure de la jonction, c'est à dire celle qui connecte le point mémoire au via, tel qu'illustré au sein de la figure 6b. Ce faisant, on récupère le caractère perpendiculaire des bit lines et des word lines.

On peut ainsi observer tout d'abord que la ligne inférieure, qui contient la couche de polarisation, n'a pas la même longueur que la ligne de contact électrique supérieure. Par ailleurs, les extrémités (à gauche et a droite) de l'élément polariseur peuvent être ainsi rapprochées du point mémoire pour augmenter le champ de polarisation.

**4. Polarisation par des aimants permanents positionnés de part et d'autre de la cellule ou point mémoire**

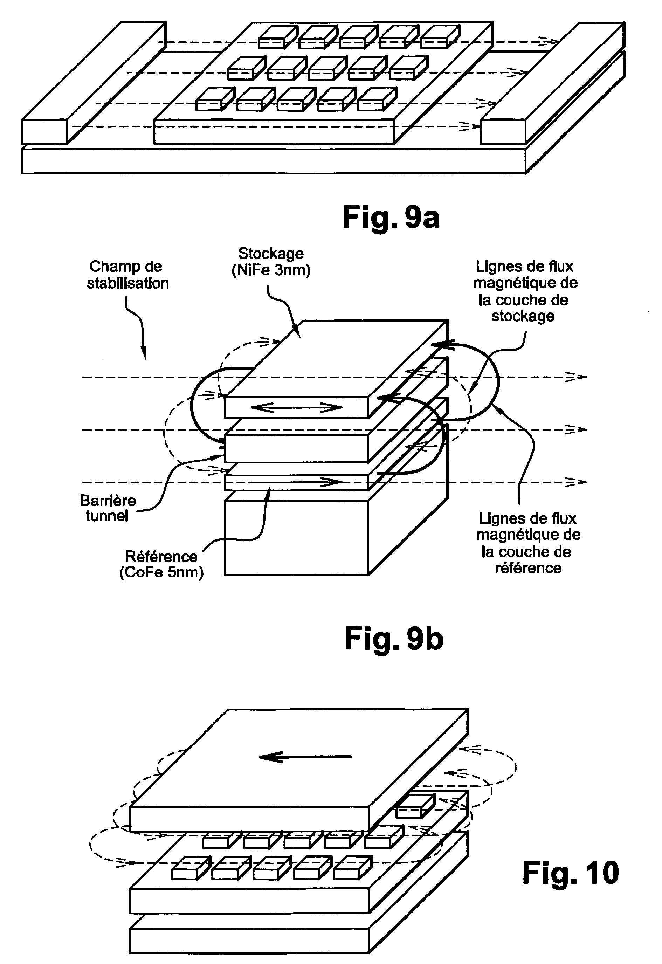

Selon un quatrième mode de réalisation de l'invention, plus particulièrement décrit en relation avec les figures 8a, 8b, 9a et 9b, deux aimants permanents latéraux placés des deux cotés de la couche de référence selon l'axe de facile aimantation rayonnent le champ de polarisation. Le champ magnétique généré par ces deux aimants polarise la direction de l'aimantation de la couche de référence. Leur position selon l'axe z est préférentiellement située au même niveau que celui de la couche de référence afin que le champ stabilisant soit maximum au niveau de ladite couche.

Le champ de polarisation est généré par des aimants permanents éloignés des points mémoire. Selon ce mode de réalisation, les points mémoires sont immergés dans le champ de polarisation rayonné par des aimants permanents susceptibles d'être séparés d'une puce intégrant une pluralité de points mémoire.

Afin que le champ de polarisation soit uniforme sur toute la surface de la puce, les points mémoire sont centrés et non pas en contact direct ou proche des surfaces latérales des aimants permanents placés de chaque coté de la puce. Le profil du champ rayonné par les aimants permanents peut être calculé en utilisant des logiciels d'éléments finis. Le positionnement de la puce mémoire est choisi en fonction du profil de champ, dans une région où le champ magnétique est suffisamment homogène. Les aimants sont placés de façon à ce que le champ de polarisation soit généré dans la direction de facile aimantation de la couche de référence. Cette approche permet l'intégration des aimants permanents après la fabrication de la matrice de points mémoire.

En référence à la figure 8b, il est possible d'observer que les aimants permanents forment des lignes englobant plus d'une cellule mémoire pour minimiser les divergences de champ stabilisant selon l'axe y, et rendre leur fabrication plus facile.

Les matériaux utilisés pour la fabrication de ces aimants stabilisants sont des couches de matériaux ferromagnétiques à forte aimantation et fort champ coercitif comme le SmCo, CoPt, CoCrPt ou FePt.

Dans un autre mode de réalisation, ils peuvent aussi être constitués d'une couche réalisée en un matériau ferromagnétique à forte aimantation, par exemple un alliage Co-Fe, piégée par une couche antiferromagnétique avec une température de blocage élevée (>200°C). Ce mode de réalisation alternatif présente l'avantage de nécessiter les mêmes matériaux déjà utilisés dans la fabrication de la cellule mémoire.

Dans les deux cas l'épaisseur de la couche ferromagnétique polarisante est ajustée en fonction du champ de polarisation nécessaire et de l'aimantation du matériau utilisé.

Comme dans le mode de réalisation précédent, le champ rayonné au niveau de la couche de stockage peut être non nul, permettant une écriture du point mémoire avec un courant unipolaire.

Le dimensionnement de l'aimantation totale de la couche de référence (en agissant sur l'épaisseur ou le matériau) permet d'annuler ou réduire le champ effectif agissant sur la couche de stockage. Le champ de polarisation présente une direction opposée au champ rayonné au niveau de la couche de stockage.

En outre, afin de minimiser le rayonnement de la couche de stockage sur la couche de référence, il est possible de réduire le moment magnétique total de la couche de stockage par réduction de l'épaisseur de la couche et/ou l'utilisation d'un matériau à faible aimantation, voire même, par la réalisation d'une couche de stockage avec une structure ferrimagnétique synthétique.

On a représenté sur la figure 9b les champs rayonnés et de polarisation. On peut ainsi observer qu'au niveau de la couche de stockage, le champ de stabilisation et le champ rayonné par la couche de référence sont opposés. Le champ rayonné par la couche de stockage peut stabiliser (ou déstabiliser) la direction de couche de référence en fonction de sa direction antiparallèle (ou parallèle) à celle de la couche de stockage.

### 5. Polarisation par un aimant permanent de polarisation au dessus de la puce

Selon un autre mode de réalisation représenté en relation avec la figure 10, le champ de polarisation est généré là aussi par un aimant permanent éloigné des points mémoire, mais situé au dessus de la puce.

Cet aimant permanent est une couche de matériau à fort moment et forte coercitivité qui couvre toute la surface de la puce.

Ce sont les lignes de champ qui se rebouclent entre le pole Nord et le pole Sud de l'aimant qui vont générer le champ de polarisation sur la puce.

Cette configuration présente l'avantage de réduire l'encombrement. Ainsi, en positionnant l'aimant permanent au dessus de la puce, cette dernière n'occupe pas plus de place.

Là encore, le dimensionnement des couches de stockage, de référence et du champ de polarisation, sont dictés par les objectifs suivants :

■ réduction ou annulation du champ effectif (résultat de la somme vectorielle du champ rayonné par la couche de référence, du champ de polarisation créé par l'aimant permanent et de l'éventuel couplage peau d'orange entre la couche de stockage et de référence) au niveau de la couche de stockage par compensation du champ magnétostatique rayonné par la couche de référence par le champ de polarisation créé par l'aimant permanent ;

■ création du champ de polarisation par l'aimant permanent au niveau de la couche de référence supérieur en module au champ rayonné par la couche de stockage au niveau de la couche de référence, l'écart entre ces deux champs devant être suffisamment grand pour permettre à l'aimantation de la couche de référence d'être maintenue parallèle au champ de polarisation quelque soit l'orientation de l'aimantation de la couche de stockage.

■ le champ magnétique généré par la ligne d'écriture peut être aussi utilisé pour renforcer l'alignement de la couche de référence selon la direction souhaité. Cella implique que lors de l'écriture d'un mot les points mémoire le long d'une ligne de champ soit écrits selon une première direction et dans un deuxième temps avec un champ qui stabilise la direction souhaité pour la couche de référence opposé a champ initial.

### 6. Point mémoire à couche de référence laminée

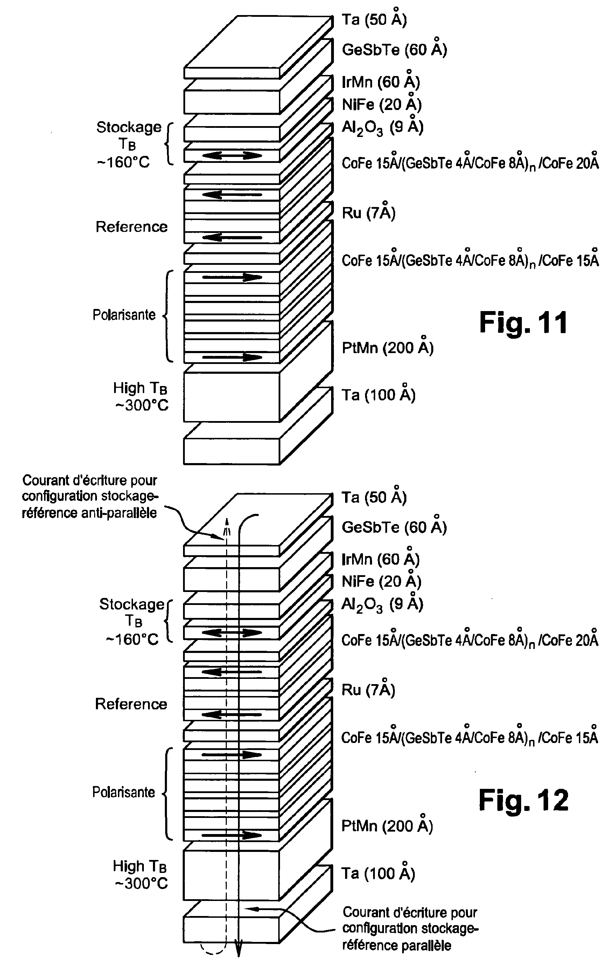

Selon un sixième mode de réalisation de l'invention illustré en relation avec la figure 11, l'empilement est constitué d'une structure à simple jonction tunnel, avec comme différence par rapport à la structure décrite dans la figure 2, l'utilisation de couches de référence et polarisante laminées.

L'idée générale de la lamination est d'introduire de nombreuses interfaces au sein des couches de référence et polarisante de sorte à en diminuer la conductivité thermique. En effet, il est connu du point de vue électrique que, par exemple, une interface Co/Ru possède la même résistance électrique qu'une couche de Co de 20nm d'épaisseur. Il en est de même pour la résistance thermique. Parce que les atomes à travers une interface sont de façon générale moins solidement liés que dans un matériau homogène et parce que les interfaces constituent souvent des discontinuités dans les structures électroniques, les interfaces présentent des résistances électriques et thermiques typiquement équivalentes à plusieurs nanomètres de matériaux homogènes. Ainsi en multipliant le nombre d'interfaces à l'intérieur des couches de référence et polarisante, on peut ainsi diminuer la conductivité thermique de ces dernières. En quelque sorte, les interfaces jouent le rôle de barrière thermique. Cette lamination peut être réalisée d'une façon ou d'une autre ou des deux façons combinées.

La première façon de laminer les couches de référence et polarisante consiste à remplacer ces simples couches par exemple de CoFe 2.5nm par des multicouches constituées de plusieurs couches ferromagnétiques d'épaisseur typique de l'ordre de 1.5nm à 3nm couplées antiparallèlement les unes aux autres par un espaceur approprié par exemple réalisé en ruthenium et d'épaisseur typiquement comprise entre 0.5nm et 0.9nm. On peut ainsi prévoir trois, quatre ou même plus de couches ferromagnétiques couplées antiparallèlement les unes aux autres, la plus éloignée de la barrière tunnel étant piégée par interaction d'échange avec une couche antiferromagnétique de piégeage par exemple réalisée en PtMn.

Par ailleurs, la couche ferromagnétique en contact direct avec la barrière tunnel peut avoir une épaisseur légèrement plus grande que les couches plus profondes à l'intérieur de cette multicouche, ceci afin de maximaliser l'amplitude de magnétorésistance de la jonction tunnel. On peut par exemple choisir une épaisseur pour la dernière couche en contact avec la barrière tunnel de l'ordre de 2.5nm alors que les couches ferromagnétiques plus profondes dans l'empilement laminé entre la barrière tunnel et la couche antiferromagnétique de piégeage peuvent avoir une épaisseur de 1.5nm.

L'avantage de cette approche réside dans la possibilité de piéger la couche polarisante par un matériau antiferromagnétique, qui ne sera pas exposée à de fortes variations de température car séparée de la barrière tunnel par tout un empilement de couches à conductivité thermique réduite.

La deuxième façon de réaliser la lamination est d'introduire au sein des couches de référence et polarisante de très fines couches de matériaux à faible conductivité thermique.

Dans ce cas, les couches laminées sont formées par insertion dans un premier matériau magnétique par exemple en CoFe de fines couches d'un deuxième matériau à faible conductivité thermique, par exemple GeSbTe. Il est aussi possible d'insérer un matériau de conductivité thermique moyenne (par exemple Ta), mais dont les interfaces avec le matériau magnétique présentent une faible conductivité thermique.

Le but de cette lamination du CoFe par insertion de fines couches par exemple de GeSbTe ou de Ta est de baisser la conductivité thermique effective de cet empilement, tout en lui conservant une cohésion magnétique suffisante. Les couches de GeSbTe ou de Ta doivent donc être suffisamment fines pour que les couches de CoFe restent fortement couplées ferromagnétiquement les unes avec les autres (typiquement en dessous de 1.5nm), mais suffisamment épaisses pour réduire la conductivité thermique de façon significative (typiquement au dessus de 0.6nm sachant que c'est d'une part l'épaisseur totale de GeSbTe ou de Ta qui va compter et aussi le nombre d'interfaces et donc de couches insérées). Si les interfaces entre le métal magnétique et ces couches insérées présentent une faible conductivité thermique, il est clair qu'on a alors intérêt à augmenter ce nombre d'interfaces en insérant un nombre important de couches de lamination. Ici encore, l'augmentation du nombre d'interfaces aide ainsi à diminuer la conductivité thermique effective de la couche laminée et agit comme une barrière thermique.

Les laminations par du matériau de faible conductivité thermique (GeSeTe ou Ta) diminuent la conductivité thermique totale des couches de référence et polarisante laminée. Ceci permet de mieux confiner la chaleur au niveau de la couche de stockage entre la première barrière thermique (couche de 6 nm de GeSbTe) et l'électrode de référence laminée. Ceci permet également de diminuer l'augmentation de température au niveau de la couche antiferromagnétique PtMn, qui piège la couche polarisante à laquelle est couplée la couche de référence. L'objectif visé est ainsi de permettre une plus large gamme de températures de fonctionnement pour réaliser l'écriture de la couche de stockage sans perdre la direction d'aimantation de l'électrode de référence ainsi réalisée.

Par ailleurs, les deux approches de lamination proposées ci-dessus peuvent être combinées c'est-à-dire qu'on peut réaliser des couches de référence et polarisante constituées d'un ensemble de couches ayant un comportement ferromagnétique couplées les unes aux autres de façon antiferromagnétiques à travers un espaceur approprié (par exemple en Ru d'épaisseur 0.6nm), chacune des couches ayant un comportement ferromagnétique étant elle-même constituée d'un empilement laminé de couches ferromagnétiques (par exemple en Co-Fe séparées par des couches ultrafines de matériaux à faible conductivité thermique (par exemple en Ta ou GeSbTe)

D'une façon générale, l'augmentation du nombre de répétitions permet de baisser encore davantage la conductance thermique de l'empilement total entre la barrière tunnel et la couche antiferromagnétique qui piège la couche de référence. Toutefois la qualité du piégeage de la couche de référence se dégrade avec l'augmentation du nombre de répétitions, et donc un compromis doit être trouvé entre réduction de la conductivité thermique et piégeage suffisant. Dans ce mode de réalisation, toutes les couches constitutives des couches de référence et polarisante ayant un comportement ferroromagnétique ne sont pas nécessairement laminées de la même manière. En particulier, il est possible de ne pas laminer la dernière couche ferromagnétique en contact avec la barrière tunnel pour éviter d'affecter par cette lamination la polarisation des électrons, tout en laminant les couches au comportement ferromagnétique plus profondes c'est à dire plus éloignées de la barrière tunnel.

Avantageusement, dans chacun des empilements laminés, les couches en contact soit avec la barrière tunnel, soit avec les couches de Ru, soit avec la couche de matériau antiferromagnétique peuvent être plus épaisses que les couches de CoFe à l'intérieur des empilements (typiquement de l'ordre de 1.5m au lieu de 0,8 à 1nm) pour permettre respectivement à l'amplitude de magnétorésistance tunnel ou au couplage antiferromagnétique à travers le Ru ou au couplage d'anisotropie d'échange ferro/antiferro d'être plus importants.

La dernière couche constitutive de la couche de référence en contact avec la barrière tunnel peut aussi être réalisée en un matériau ferromagnétique autre que le CoFe, si cela est nécessaire à la croissance de la barrière tunnel, comme dans le cas d'une barrière de MgO, qui est normalement élaborée sur une couche de CoFeB.

Au sein de l'exemple décrit (Figure.11), les épaisseurs des couches laminées CoFe 8Å et GeSbTe 4Å sont choisis pour maintenir un couplage ferromagnétique direct entre la première et dernière laminations de CoFe. Cette lamination est répétée n fois pour assurer l'isolation thermique de la couche de PtMn.

Bien évidemment, l'utilisation de telles couches de références laminées peut aussi se concevoir dans le cadre de structures duales du type de celle décrite en relation avec la figure 5, mettant en oeuvre deux barrières tunnel avec une couche de stockage centrale. Dans cette configuration, ce sont les deux empilements CoFe/GeSbTe/CoFe/PtMn de la figure 5 qui sont remplacés par les couches laminées (CoFe/GeSbTe)/CoFe/Ru/CoFe (GeSbTe/CoFe)/PtMn.

### 7. Ecriture par transfert de spin

Dans le cadre du mode de fonctionnement décrit précédemment, l'écriture du point mémoire s'effectue par l'application d'un champ magnétique généré par le passage d'un courant électrique dans une ligne de courant située à proximité du point mémoire, en général au dessus de lui comme illustré sur la figure 2 par exemple. Ce champ est appliqué lorsque la température de blocage de la couche antiferromagnétique qui piège la couche ferromagnétique de stockage est dépassé et pendant le refroidissement du point mémoire, refroidissement provoqué par l'arrêt du courant de chauffage qui traverse la jonction tunnel. La nouvelle direction de l'aimantation de la couche de stockage est déterminée par la direction de ce champ appliqué généré par la ligne de courant qui est maintenu pendant le temps de refroidissement de la jonction.

Dans un mode d'écriture alternatif, il est possible d'utiliser la polarisation en spin du courant qui traverse la jonction pour agir directement sur la direction d'aimantation de la couche de stockage. Ce mode d'écriture connu sous le nom de transfert de spin utilise le fait que les électrons qui pénètrent dans la couche de stockage en provenance de la couche de référence sont polarisés en spin. Après avoir traversé la barrière qui sépare les deux électrodes ferromagnétiques de la jonction, les spins des électrons pénétrant dans la couche de stockage sont réorientés selon la direction d'aimantation de la couche de stockage, en exerçant un couple sur son aimantation qui pour des densités de courant de l'ordre de $10^5$-$10^7$A/cm$^2$, est suffisamment fort pour retourner l'aimantation de la couche de stockage. L'écriture est alors déterminée par le sens du courant envoyé. Si les électrons circulent de la couche de référence vers la couche de stockage, le courant polarisé en spin favorise une configuration parallèle des couches de stockage et de référence (état de basse résistance). Pour une circulation des électrons dans le sens opposé, c'est la configuration antiparallèle (état de haute résistance) qui est favorisée. Le courant critique pour le renversement de la couche de stockage n'est pas nécessairement symétrique en raison des champs magnétostatiques présents et d'une dissymétrie intrinsèque du phénomène de transfert de spin.

Ce mode d'écriture peut aussi être réalisé dans une cellule avec une couche de stockage constituée d'une électrode ferromagnétique (NiFe, CoFeB, CoFe 1-4nm) piégée par une couche antiferromagnétique (IrMn 6nm) avec une faible température de blocage (160°C). La couche de référence peut être réalisée selon les six méthodes décrites précédemment. Par exemple, la couche de référence peut être constituée d'une couche ferromagnétique laminée couplée antiferromagnétiquement à une couche polarisante qui se trouve piégée par une couche antiferromagnétique (PtMn, IrMn, NiMn 10-25nm) avec une haute température de blocage (>250°C) (PtMn sur la figure 12). La deuxième couche laminée (couche de référence) est polarisée par un couplage antiferromagnétique à travers un espaceur réalisé en Ruthénium, d'épaisseur typique comprise entre 0,5 nm et 1 nm.

Ce mode de fonctionnement est décrit par exemple dans le document EP 1 466 329. Pour le mode d'écriture utilisant le courant polarisé en spin, il est nécessaire que le courant critique pour le retournement de la couche de stockage soit inférieur au courant nécessaire pour atteindre une augmentation de température de la couche antiferromagnétique qui piège la couche de stockage au-delà de sa température de blocage. Ainsi, la réorientation de l'aimantation de la couche de stockage dans un sens ou dans l'autre suivant la direction du sens du courant traversant la jonction tunnel, s'effectue dés que cette température de blocage est dépassée.

La polarisation de la couche de référence peut être réalisée selon les méthodes décrites précédemment en relation avec les six modes de réalisation.

La figure 12 illustre la réalisation d'une écriture d'un point mémoire avec un courant polarisé en spin et une polarisation de la couche de référence telle que décrite dans le dernier mode de réalisation décrit (section 6). La barrière tunnel qui sépare les deux électrodes doit être de faible épaisseur pour permettre un flux d'électrons par effet tunnel important. Pour permettre des densités de courant élevées (>$10^5$A/cm$^2$) sous des tensions inférieures à la tension de claquage de la jonction, le produit RA caractéristique de ces barrières doit être compris entre 1 et 100 $\Omega.\mu m^2$.

Ces barrières peuvent être réalisées en Al$_2$O$_3$, TiO$_2$ ou MgO pour des épaisseurs typiques de 0,5 à 2nm. Pour augmenter l'efficacité du chauffage et confiner la chaleur à la jonction, l'ensemble couche de référence - barrière tunnel - couche de stockage est placé entre deux barrières thermiques.

Les couches de polarisation et de référence ferromagnétiques sont laminées par un matériau à faible conductivité thermique (par exemple GeSbTe). La polarisation de la couche de référence est réalisée par une couche polarisante piégée. La couche antiferromagnétique de piégeage (PtMn) est située à l'extérieur de la zone délimitée par les barrières thermiques. Ce mode de réalisation simplifie l'architecture de la mémoire car il ne nécessite pas une ligne de courant supplémentaire pour générer un champ magnétique.

Au sein de cette figure 12, on a représenté par une flèche sensiblement verticale et ascendante, matérialisée en traits pointillés le courant d'écriture pour configurer les couches de stockage et de référence en mode anti-parallèle, et par une flèche sensiblement verticale et descendante, matérialisé en trait plein, le sens du courant d'écriture pour configurer les couches de stockage et de référence en mode parallèle.

### Revendications

**1.** Mémoire magnétique à écriture assistée thermiquement, dont chaque point mémoire est constitué d'au moins une jonction tunnel magnétique, ladite jonction tunnel comprenant au moins :

- une couche magnétique de référence, dont l'aimantation est orientée toujours dans la même direction au moment de la lecture du point mémoire;
- une couche magnétique de stockage, dite couche « libre », dont la direction d'aimantation est variable ;
- une couche isolante interposée entre la couche de référence et la couche de stockage,

*caractérisée* **en ce qu'**elle comporte également un élément magnétique d'aimantation fixe, cet élément étant en couplage magnétostatique avec la couche de référence et étant soumis à des variations de température moindres que ladite couche de référence, lors des phases d'écriture et de lecture.

2. Mémoire magnétique à écriture assistée thermiquement selon la revendication *1, caractérisée* **en ce que** le couplage magnétostatique entre l'élément magnétique et la couche de référence est renforcé par un couplage antiferromagnétique.

3. Mémoire magnétique à écriture assistée thermiquement selon la revendication 1, *caractérisée* **en ce que** la couche de stockage est composée d'un bicouche associant d'une part une couche en un matériau ferromagnétique, typiquement choisi dans le groupe comprenant le Permalloy ($Ni_{80}Fe_{20}$) et le $Co_{90}Fe_{10}$ et d'autre part une couche antiferromagnétique de température de blocage modérée.

4. Mémoire magnétique à écriture assistée thermiquement selon l'une des revendications 1 ou 3, *caractérisée* **en ce que** l'élément magnétique d'aimantation fixe est constitué d'une couche polarisante composée d'un bicouche associant d'une part une couche en un matériau ferromagnétique, typiquement en alliage $Co_{1-x}Fe_x$, x étant compris entre 0 et 0.50, et d'autre part une couche antiferromagnétique de température de blocage élevée.

5. Mémoire magnétique à écriture assistée thermiquement selon l'une des revendications 1 ou 3, *caractérisée* **en ce que** l'élément magnétique d'aimantation fixe est constitué d'une couche polarisante réalisée en un matériau à forte coercivité, réalisée en un matériau choisi dans le groupe comprenant le $Co_{80}Cr_{20}$ et le SmCo.

6. Mémoire magnétique à écriture assistée thermiquement selon l'une des revendications 1 ou 3 à 5, *caractérisée* **en ce que** la couche polarisante est insérée à l'intérieur de la ligne conductrice qui assure la connexion électrique au point mémoire, et **en ce que** la direction de son aimantation est substantiellement perpendiculaire à la longueur de la ligne.

7. Mémoire magnétique à écriture assistée thermiquement selon la revendication 6, *caractérisée* **en ce que** la ligne conductrice est constituée de la couche polarisante, d'une couche antiferromagnétique de piégeage, et complétée par une couche conductrice non-magnétique, lesdites couches polarisante et antiferromagnétique de piégeage étant de même nature que celle de la couche polarisante selon la revendication 5.

8. Mémoire magnétique à écriture assistée thermiquement selon l'une des revendications 1 ou 3 à 7, *caractérisée* **en ce que** la couche de référence est réalisée en un matériau ferromagnétique, choisi dans le groupe comprenant un alliage de CoFe ($Co_{90}Fe_{10}$, $Co_{70}Fe_{30}$, $Co_{80}Fe_{10}B_{10}$), de NiFe ($Ni_{80}Fe_{20}$), ou d'une bicouche CoFe 1nm/NiFe 2nm et **en ce que** l'épaisseur totale de la couche de référence est comprise entre 1 et 4nm.

9. Mémoire magnétique selon l'une quelconque des revendications 1 ou 3 à 8, *caractérisée* **en ce qu'**une couche de faible conductivité thermique servant de barrière thermique, est interposée entre la couche de référence et l'élément magnétique ou couche polarisante.

10. Mémoire magnétique à écriture assistée thermiquement selon la revendication *9, caractérisée* **en ce que** la couche de stockage est en contact sur sa face opposée par rapport à la barrière tunnel avec une couche de très faible conductivité thermique servant de barrière thermique.

11. Mémoire magnétique à écriture assistée thermiquement selon la revendication *9, caractérisée* **en ce que** chaque point mémoire est constitué d'une double jonction tunnel magnétique ayant en commun une seule couche de stockage, ladite couche de stockage étant insérée entre les deux barrières tunnel de chacune des jonctions tunnel, chaque barrière tunnel ayant du côté opposé à la couche de stockage une couche de référence, l'aimantation de ces couches de référence étant couplées magnétostatiquement avec une couche polarisante d'aimantation piégée, les deux couches de référence étant séparées des deux couches polarisantes auxquelles elles sont respectivement magnétostatiquement couplées par une barrière thermique.

12. Mémoire magnétique à écriture assistée thermiquement selon l'une des revendications 1 ou 3 à 8, *caractérisée* **en ce que** l'élément magnétique d'aimantation fixe en interaction magnétostatique avec la couche de référence est constitué d'aimants permanents positionnés de part et d'autre du point mémoire, et **en ce que** les aimants permanents sont constitués de couches de matériaux ferromagnétiques à forte aimantation et fort champs coercitif, choisis dans le groupe comprenant SmCo, CoPt, Co-CrPt et FePt ou sont constitués de matériaux ferromagnétiques à forte aimantation, notamment réalisés à base d'un alliage CoFe, piégés par une couche antiferromagnétique avec une température de blocage élevée, notamment supérieure à 200°C.

13. Mémoire magnétique à écriture assistée thermiquement selon l'une des revendications 1 ou 3 à 8, *caractérisée* **en ce que** l'élément magnétique d'aimantation fixe en interaction magnétostatique avec la couche de référence est constitué d'un aimant permanent positionné au dessus de la mémoire.

14. Mémoire magnétique à écriture assistée thermiquement selon l'une des revendications 1 à 3, *caractérisée* **en ce que** la couche de référence est constituée d'un ensemble de couches ferromagnétiques couplées antiferromagnétiquement à travers un espaceur non-magnétique notamment réalisé en ruthenium.

15. Mémoire magnétique à écriture assistée thermiquement selon l'une des revendications 1 à 3, *caractérisée* **en ce que** l'élément magnétique d'aimantation fixe en interaction magnétostatique avec la couche de référence est constitué d'un ensemble de couches ferromagnétiques couplées antiferromagnétiquement à travers un espaceur non-magnétique notamment réalisé en ruthenium.

16. Mémoire magnétique à écriture assistée thermiquement selon la revendication *9, caractérisée* **en ce que** la couche de référence est laminée par insertion dans un premier matériau magnétique, notamment du CoFe, de fines couches d'un deuxième matériau à faible conductivité thermique, notamment GeSbTe ou Ta

17. Mémoire magnétique à écriture assistée thermiquement selon la revendication *9, caractérisée* **en ce que** l'élément magnétique d'aimantation fixe en interaction magnétostatique avec la couche de référence est constitué d'une couche de polarisation laminée par insertion dans un premier matériau magnétique, notamment du CoFe, de fines couches d'un deuxième matériau à faible conductivité thermique, notamment GeSbTe ou Ta.

18. Mémoire magnétique à écriture assistée thermiquement selon l'une des revendications l'une quelconque des revendications 1 à 8, *caractérisée* **en ce que** l'élément magnétique d'aimantation fixe en interaction magnétostatique avec la couche de référence est constitué d'une couche polarisante piégée par une couche antiferromagnétique, notamment en PtMn, la couche de référence étant polarisée par ladite couche polarisante par couplage antiferromagnétique à travers un espaceur réalisé en Ruthénium, ce couplage venant s'ajouter au couplage magnétostatique entre ces couches.

19. Mémoire magnétique à écriture assistée thermiquement selon l'une quelconque des revendications 1 à 4, 8 à 10 et 13 à 17, *caractérisée* **en ce que** le nombre d'empilements couplés antiparallèlement par une couche de Ruthénium et constitués par l'ensemble couche de référence laminée / couche polarisante laminée est supérieur à deux, l'empilement le plus éloigné de la barrière tunnel étant piégé par interaction avec une couche en un matériau antiferromagnétique.

**Claims**

1. A magnetic memory with a thermally-assisted write, every storage cell of which consisting of at least one magnetic tunnel junction, said tunnel junction comprising at least:

   - one magnetic reference layer, the magnetization of which is always oriented in the same direction at the time of the read of the storage cell;
   - one so-called "free" magnetic storage layer, the magnetization direction of which is variable;
   - one insulating layer sandwiched between the reference layer and the storage layer,

   *characterized* **in that** it further comprises a fixed-magnetization magnetic element, which is in a magnetostatic interaction with the reference layer and being subjected, during read phases and write phases, to thermal variations that are less than those to which the reference layer with which it interacts magnetostatically is subjected.

2. The magnetic memory with a thermally-assisted write as claimed in claim 1, *characterized* **in that** the magnetostatic interaction between the magnetic element and the reference layer is increased by an antiferromagnetic interaction.

3. The magnetic memory with a thermally-assisted write as claimed in claim 1, *characterized* **in that** the storage layer comprises a bilayer that associates firstly a layer of a ferromagnetic material, typically selected from the group comprising Permalloy ($Ni_{80}Fe_{20}$) and $Co_{90}Fe_{10}$ and secondly an antiferromagnetic layer having a moderate blocking temperature.

**4.** The magnetic memory with a thermally-assisted write as claimed in claim 1 to *3, characterized* in **that** the fixed magnetization magnetic element comprises a polarization layer made of a bilayer which associates firstly a layer of a ferromagnetic material, typically a $Co_{1-x}Fe_x$ alloy, x being 0 to 0.50, and secondly an antiferromagnetic layer having a high blocking temperature.

**5.** The magnetic memory with a thermally-assisted write as claimed in claim 1 or 3, *characterized* in **that** the fixed magnetization magnetic element is constituted by a polarizing layer made of a material with high coercivity made from a material selected from the group comprising $Co_{80}Cr_{20}$ and SmCo.

**6.** The magnetic memory with a thermally-assisted write as claimed in claim 1 or 3 - *5, characterized* **in that** the polarizing layer is inserted in the line which ensures electrical connection to the storage cell and **in that** its magnetization direction is substantially perpendicular to the length of the line.

**7.** The magnetic memory with a thermally-assisted write as claimed in claim 6, *characterized* **in that** the conductive line consists of the polarizing layer, an antiferromagnetic pinning layer and is supplemented by a non-magnetic conductive layer, said polarizing and antiferromagnetic pinning layers being of the same kind as that in claim 5.

**8.** The magnetic memory with a thermally-assisted write as claimed in claim 1 or 3 to *7, characterized* **in that** the reference layer is made of a ferromagnetic material selected from the group comprising an alloy of CoFe ($Co_{90}Fe_{10}$, $Co_{70}Fe_{30}$, $Co_{80}Fe_{10}B_{10}$), of NiFe ($Ni_{80}Fe_{20}$) or a 1 nm CoFe/2 nm NiFe bilayer, and **in that** the total thickness of the reference layer is 1 to 4 nm.

**9.** The magnetic memory with a thermally-assisted write as claimed in claim 1 or 3 to *7, characterized* **in that** a layer of low thermal conductivity acting as a thermal barrier is placed between the reference layer and the magnetic element or polarizing layer.

**10.** The magnetic memory with a thermally-assisted write as claimed in claim 9, *characterized* **in that** the side of the storage layer opposite the tunnel barrier is in contact with a layer of very low thermal conductivity used as a thermal barrier.

**11.** The magnetic memory with a thermally-assisted write as claimed in claim 9, *characterized* **in that** every storage cell consists of a double magnetic tunnel junction having a single storage layer in common, said storage layer being inserted between the two tunnel barriers of each of the tunnel junctions, each tunnel barrier having, on the side opposite the storage layer, a reference layer, the magnetization of which being in magnetostatic interaction with a pinned magnetization polarizing layer, the two reference layers being separated from the two polarizing layers with which they are respectively magnetostatically coupled by a thermal barrier.

**12.** The magnetic memory with a thermally-assisted write as claimed in claim 1 or 3 to *8, characterized* **in that** the fixed magnetization magnetic element in magnetostatic interaction with the reference layer consists of permanent magnets placed either side of the storage cell, and **in that** the permanent magnets consist of layers of strongly magnetic ferromagnetic materials with high coercive fields selected from the group comprising SmCo, CoPt, CoCrPt and FePt or consist of strongly magnetic ferromagnetic materials, particularly those based on a CoFe alloy and pinned by an antiferromagnetic layer with a high blocking temperature in excess of 200 °C in particular.

**13.** The magnetic memory with a thermally-assisted write as claimed in claim 1 or 3 to *8, characterized* **in that** the fixed magnetization magnetic element in magnetostatic interaction with the reference layer consists of a permanent magnet located above the memory.

**14.** The magnetic memory with a thermally-assisted write as claimed in claim 1 to 3, *characterized* in **that** the reference layer consists of a number of ferromagnetic layers which are antiferromagnetically coupled through a non-magnetic spacer, especially one made of ruthenium.

**15.** The magnetic memory with a thermally-assisted write as claimed in claim 1 to 3, *characterized* in **that** the fixed magnetization magnetic element in magnetostatic interaction with the reference layer consists of a number of ferromagnetic layers which are antiferromagnetically coupled through a non-magnetic spacer, especially one made of ruthenium.

**16.** The magnetic memory with a thermally-assisted write as claimed in claim 9, *characterized* **in that** the reference layer is laminated and produced by inserting, into a first magnetic material, especially CoFe, thin layers of a second material with a low thermal conductivity, especially GeSbTe or Ta.

**17.** The magnetic memory with a thermally-assisted write as claimed in claim 9, *characterized* **in that** the fixed magnetization magnetic element in magnetostatic interaction with the reference layer consist in a polarizing layer which is laminated and produced by inserting, into a first magnetic material, especially CoFe, thin layers of a second material with a low thermal conductivity, especially GeSbTe or Ta.

18. The magnetic memory with a thermally-assisted write as claimed in claim 1 to 8, *characterized* **in that** that the fixed magnetization magnetic element in magnetostatic interaction with the reference layer consists in a polarizing layer which is pinned by an antiferromagnetic layer, especially one made of Pt-Mn, with the reference layer being polarized by said polarizing layer by antiferromagnetic coupling through a spacer made of ruthenium, this coupling being added to the magnetostatic coupling between these layers.

19. The magnetic memory with a thermally-assisted write as claimed in claim 1 to4, 7 to 10 and 13 to 17, *characterized* **in that** the number of stacks coupled in antiparallel by one ruthenium layer and consisting of the laminated reference layer/laminated polarizing layer assembly is greater than two, with the stack farthest from the tunnel barrier being pinned by interaction with a layer made of an antiferromagnetic material.

**Patentansprüche**

1. Magnetspeicher mit wärmeunterstützter Beschriftung, bei dem jeder Speicherpunkt aus zumindest einem Magnettunnelübergang besteht, wobei der Tunnelübergang zumindest aufweist:

   - eine magnetische Referenzschicht, deren Magnetisierung zum Zeitpunkt des Auslesens des Speicherpunktes stets in der gleichen Richtung ausgerichtet ist;
   - eine magnetische Speicherschicht, die sogenannte "freie" Schicht, deren Magnetisierungsrichtung veränderlich ist;
   - eine zwischen die Referenzschicht und die Speicherschicht eingebrachte Isolierschicht;

   **dadurch gekennzeichnet, dass** er auch ein Magnetelement mit fester Magnetisierung aufweist, wobei dieses Element magnetostatisch mit der Referenzschicht gekoppelt ist und während der Beschriftungs- und Lesephasen geringeren Temperaturschwankungen unterliegt als die Referenzschicht.

2. Magnetspeicher mit wärmeunterstützter Beschriftung nach Anspruch 1, **dadurch gekennzeichnet, dass** die magnetostatische Kopplung zwischen dem Magnetelement und der Referenzschicht durch eine antiferromagnetische Kopplung verstärkt wird.

3. Magnetspeicher mit wärmeunterstützter Beschriftung nach Anspruch 1, **dadurch gekennzeichnet, dass** die Speicherschicht aus einem Zweischichtsystem zusammengesetzt ist, das einerseits eine Schicht aus einem ferromagnetischen Material, typischerweise ausgewählt aus der Gruppe umfassend Permalloy ($Ni_{80}Fe_{20}$) und $Co_{90}Fe_{10}$, und andererseits eine antiferromagnetische Schicht mit mäßiger Sperrtemperatur verbindet.

4. Magnetspeicher mit wärmeunterstützter Beschriftung nach einem der Ansprüche 1 oder 3, **dadurch gekennzeichnet, dass** das Magnetelement mit fester Magnetisierung aus einer polarisierenden Schicht besteht, die aus einem Zweischichtsystem zusammengesetzt ist, das einerseits eine Schicht aus einem ferromagnetischen Material, typischerweise aus einer $Co_{1-x}Fe_x$-Legierung, wobei x zwischen 0 und 0,50 liegt, und andererseits eine antiferromagnetische Schicht mit erhöhter Sperrtemperatur verbindet.

5. Magnetspeicher mit wärmeunterstützter Beschriftung nach einem der Ansprüche 1 oder 3, **dadurch gekennzeichnet, dass** das Magnetelement mit fester Magnetisierung aus einer polarisierenden Schicht besteht, die aus einem Material mit starker Koerzitivkraft und aus einem Material, ausgewählt aus der Gruppe umfassend $Co_{80}Cr_{20}$ und SmCo, hergestellt ist.

6. Magnetspeicher mit wärmeunterstützter Beschriftung nach einem der Ansprüche 1 oder 3 bis 5, **dadurch gekennzeichnet, dass** die polarisierende Schicht innerhalb der Leitung eingefügt ist, welche für die Stromverbindung mit dem Speicherpunkt sorgt, und dass die Richtung ihrer Magnetisierung im wesentlichen senkrecht zur Länge der Leitung verläuft.

7. Magnetspeicher mit wärmeunterstützter Beschriftung nach Anspruch 6, **dadurch gekennzeichnet, dass** die Leitung aus der polarisierenden Schicht und aus einer antiferromagnetischen Festlegungsschicht besteht und von einer nichtmagnetischen Leiterschicht ergänzt wird, wobei die polarisierende Schicht und die antiferromagnetische Festlegungsschicht von gleicher Beschaffenheit wie die polarisierende Schicht nach Anspruch 5 ist.

8. Magnetspeicher mit wärmeunterstützter Beschriftung nach einem der Ansprüche 1 oder 3 bis 7, **dadurch gekennzeichnet, dass** die Referenzschicht aus einem ferromagnetischem Material, ausgewählt aus der Gruppe umfassend eine Legierung aus Co-Fe ($Co_{90}Fe_{10}$, $Co_{70}Fe_{30}$, $Co_{80}Fe_{10}B_{10}$), NiFe ($Ni_{80}Fe_{20}$) oder aus einem Zweischichtsystem CoFe 1 nm / NiFe 2 nm, hergestellt ist und dass die Gesamtdicke der Referenzschicht zwischen 1 und 4 nm beträgt.

9. Magnetspeicher nach einem der Ansprüche 1 oder 3 bis 8, **dadurch gekennzeichnet, dass** eine Schicht geringer Wärmeleitfähigkeit, die als Wärmesperre dient, zwischen die Referenzschicht und das Magnetelement bzw. die polarisierende Schicht eingefügt ist.

10. Magnetspeicher mit wärmeunterstützter Beschriftung nach Anspruch 9, **dadurch gekennzeichnet, dass** die Speicherschicht an ihrer der Tunnelbarriere entgegengesetzten Seite mit einer Schicht sehr geringer Wärmeleitfähigkeit in Kontakt steht, die als Wärmesperre dient.

11. Magnetspeicher mit wärmeunterstützter Beschriftung nach Anspruch 9, **dadurch gekennzeichnet, dass** jeder Speicherpunkt aus einem zweifachen Magnettunnelübergang besteht, der eine einzige Speicherschicht gemein hat, wobei die Speicherschicht zwischen die beiden Tunnelbarrieren eines jeden der Tunnelübergänge eingefügt ist, wobei jede Tunnelbarriere auf der der Speicherschicht entgegengesetzten Seite eine Referenzschicht aufweist, wobei die Magnetisierung dieser Referenzschichten magnetostatisch mit einer polarisierenden Schicht mit festgelegter Magnetisierung gekoppelt ist, wobei die beiden Referenzschichten von den beiden polarisierenden Schichten getrennt sind, mit denen sie jeweils über eine Wärmesperre magnetostatisch gekoppelt sind.

12. Magnetspeicher mit wärmeunterstützter Beschriftung nach einem der Ansprüche 1 oder 3 bis 8, **dadurch gekennzeichnet, dass** das mit der Referenzschicht in magnetostatischer Wechselwirkung stehende Magnetelement mit fester Magnetisierung aus Permanentmagneten besteht, die beiderseits des Speicherpunktes positioniert sind, und dass die Permanentmagnete aus Schichten aus ferromagnetischen Materialien mit starker Magnetisierung und starken Koerzitivfeldern bestehen, die ausgewählt sind aus der Gruppe umfassend SmCo, CoPt, CoCrPt und FePt oder aus ferromagnetischen Materialien mit starker Magnetisierung bestehen, die insbesondere auf Basis einer CoFe-Legierung hergestellt sind und über eine antiferromagnetische Schicht mit einer erhöhten Sperrtemperatur von insbesondere über 200°C festgelegt sind.

13. Magnetspeicher mit wärmeunterstützter Beschriftung nach einem der Ansprüche 1 oder 3 bis 8, **dadurch gekennzeichnet, dass** das mit der Referenzschicht in magnetostatischer Wechselwirkung stehende Magnetelement mit fester Magnetisierung aus einem Permanentmagneten besteht, der über dem Speicher positioniert ist.

14. Magnetspeicher mit wärmeunterstützter Beschriftung nach einem der Ansprüche 1 bis 3, **dadurch gekennzeichnet, dass** die Referenzschicht aus einer Einheit von ferromagnetischen Schichten besteht, die über einen insbesondere aus Ruthenium hergestellten nichtmagnetischen Abstandhalter antiferromagnetisch gekoppelt sind.

15. Magnetspeicher mit wärmeunterstützter Beschriftung nach einem der Ansprüche 1 bis 3, **dadurch gekennzeichnet, dass** das das mit der Referenzschicht in magnetostatischer Wechselwirkung stehende Magnetelement mit fester Magnetisierung aus einer Einheit von ferromagnetischen Schichten besteht, die über einen insbesondere aus Ruthenium hergestellten nichtmagnetischen Abstandhalter antiferromagnetisch gekoppelt sind.

16. Magnetspeicher mit wärmeunterstützter Beschriftung nach Anspruch 9, **dadurch gekennzeichnet, dass** die Referenzschicht dadurch laminiert wird, dass in ein erstes magnetisches Material, insbesondere CoFe, feine Schichten eines zweiten Materials mit geringer Wärmeleitfähigkeit, insbesondere GeSbTe oder Ta, eingebracht werden.

17. Magnetspeicher mit wärmeunterstützter Beschriftung nach Anspruch 9, **dadurch gekennzeichnet, dass** das mit der Referenzschicht in magnetostatischer Wechselwirkung stehende Magnetelement mit fester Magnetisierung aus einer polarisierenden Schicht besteht, die dadurch laminiert wird, dass in ein erstes magnetisches Material, insbesondere CoFe, feine Schichten eines zweiten Materials mit geringer Wärmeleitfähigkeit, insbesondere GeSbTe oder Ta, eingebracht werden.

18. Magnetspeicher mit wärmeunterstützter Beschriftung nach einem der Ansprüche 1 bis 8, **dadurch gekennzeichnet, dass** das mit der Referenzschicht in magnetostatischer Wechselwirkung stehende Magnetelement mit fester Magnetisierung aus einer polarisierenden Schicht besteht, die über eine antiferromagnetische Schicht, insbesondere aus PtMn, festgelegt ist, wobei die Referenzschicht durch antiferromagnetische Kopplung durch einen aus Ruthenium hergestellten Abstandhalter über die polarisierende Schicht polarisiert wird, wobei diese Kopplung zur magnetostatischen Kopplung zwischen diesen Schichten hinzukommt.

19. Magnetspeicher mit wärmeunterstützter Beschriftung nach einem der Ansprüche 1 bis 4, 8 bis 10 und 13 bis 17, **dadurch gekennzeichnet, dass** die Anzahl an Stapel, die über eine Ruthenium-Schicht antiparallel gekoppelt sind und aus der Einheit von la-

**EP 2 140 455 B1**

minierter Referenzschicht/laminierter Polarisationsschicht bestehen, größer als zwei ist, wobei der am weitesten von der Tunnelbarriere entfernt liegende Stapel durch die Wechselwirkung mit einer Schicht aus einem antiferromagnetischen Material festgelegt wird.

**Fig. 1**

**Fig. 2**

**Fig. 3a**

**Fig. 3b**

GeSbTe (10 nm)

IrMn (6 nm)

NiFe (2 nm)

CoFe (5nm)

GeSbTe (8 nm)

CoFe (5nm)

PtMn (20 nm)

## Fig. 4

Ta (50 Å)

PtMn (200 Å)

Polarisante 2
High $T_B$
~300°C

CoFe (40 Å)

GeSbTe (60 Å)

CoFe (40 Å)

Al$_2$O$_3$ (9 Å)

Reference 2

NiFe (20 Å)

IrMn (60 Å)

NiFe (20 Å)

Stockage
$T_B$
~160°C

Al$_2$O$_3$ (9 Å)

CoFe (40 Å)

Reference 1

GeSbTe (80 Å)

CoFe (40 Å)

## Fig. 5

PtMn (200 Å)

Polarisante 1
High $T_B$
~300°C

Ta (100 Å)

**Fig. 6a**

Ligne isolée électriquement de la jonction pour génération du champ magnétique

$I$ écriture

Word Line

Ligne connectée électriquement au sommet de la jonction

Cu (200 Å)

PtMn (200 Å)    Bit Line

CoFe (80 Å)

Polarisante High T$_B$ ~300°C

Ta (1200 Å)

GeSbTe (80 Å)

Reference

CoFe (40 Å)

Al$_2$O$_3$ (9 Å)

NiFe (20 Å)

IrMn (60 Å)

Stockage Low T$_B$ ~160°C

GeSbTe (60 Å)

Ta (50 Å)

Sélection Line

EP 2 140 455 B1

**Fig. 6b**

Bit Line

Word Line

Selection Line

**Fig. 7**

- Ta (50 Å)
- GeSbTe (60 Å)
- IrMn (60 Å)
- Co 5 A/(Pt 5 A/Co 3 Å)₂
- Al₂O₃ (9 Å)
- Co 3 Å/(Pt 5 A/Co 3 Å)₂ /Co2Å
- Ru (7 Å)
- Co 3 Å/(Pt 5 Å/Co 3 Å)₂
- GeSbTe (80 Å)
- Co 3 Å/(Pt 5 A/Co 3 Å)₂
- PtMn (200 Å)
- Ta (100 Å)

Stockage T_B ~160°C

Reference

Polarisante High T_B ~300°C

**Fig. 8b**

Y
X

Stockage T_B ~160°C

- Ta (50 Å)
- GeSbTe (60 Å)
- IrMn (60 Å)
- NiFe (20Å)
- Al₂O₃ (9 Å)
- CoFe (40Å)
- GeSbTe (80 Å)
- Reference
- Ta (100 Å)

Z Y X

**Fig. 8a**

## Fig. 9a

Champ de stabilisation

Stockage (NiFe 3nm)

Lignes de flux magnétique de la couche de stockage

Barrière tunnel

Référence (CoFe 5nm)

Lignes de flux magnétique de la couche de référence

## Fig. 9b

## Fig. 10

Ta (50 Å)

GeSbTe (60 Å)

IrMn (60 Å)

NiFe (20 Å)

Al$_2$O$_3$ (9 Å)

CoFe 15Å/(GeSbTe 4Å/CoFe 8Å)$_n$ /CoFe 20Å

Stockage T$_B$ ~160°C

Reference

Ru (7Å)

CoFe 15Å/(GeSbTe 4Å/CoFe 8Å)$_n$ /CoFe 15Å

Polarisante

PtMn (200 Å)

High T$_B$ ~300°C

Ta (100 Å)

**Fig. 11**

Courant d'écriture pour configuration stockage-référence anti-parallèle

Ta (50 Å)

GeSbTe (60 Å)

IrMn (60 Å)

NiFe (20 Å)

Al$_2$O$_3$ (9 Å)

Stockage T$_B$ ~160°C

CoFe 15Å/(GeSbTe 4Å/CoFe 8Å)$_n$ /CoFe 20Å

Reference

Ru (7Å)

CoFe 15Å/(GeSbTe 4Å/CoFe 8Å)$_n$ /CoFe 15Å

Polarisante

**Fig. 12**

PtMn (200 Å)

High T$_B$ ~300°C

Ta (100 Å)

Courant d'écriture pour configuration stockage-référence parallèle

28

EP 2 140 455 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4949039 A
- US 5159513 A
- US 5343422 A
- US 5640343 A
- US 6021065 A
- US 5583725 A
- US 6385082 A
- FR 2829867
- FR 2829868
- EP 1466329 A

**Littérature non-brevet citée dans la description**

- *Journal of Applied Physics,* 1997, vol. 81, 3758
- **Y.SAITO et al.** *Journal of Magnetism and Magnetic Materials,* 2001, vol. 223, 293